Europäisches Patentamt

(19) European Patent Office

Office européen des brevets

(11) **EP 1 317 829 B1**

(12) **EUROPÄISCHE PATENTSCHRIFT**

(45) Veröffentlichungstag und Bekanntmachung des Hinweises auf die Patenterteilung:
**08.06.2005 Patentblatt 2005/23**

(21) Anmeldenummer: **01965245.2**

(22) Anmeldetag: **04.09.2001**

(51) Int Cl.7: **H04L 25/03**, H04L 27/34

(86) Internationale Anmeldenummer:
**PCT/EP2001/010140**

(87) Internationale Veröffentlichungsnummer:
**WO 2002/021783 (14.03.2002 Gazette 2002/11)**

(54) **VERFAHREN ZUM CODIEREN UND DECODIEREN EINES INFORMATIONSSYMBOLS**

METHOD FOR CODING AND DECODING AN INFORMATION SYMBOL

PROCEDE POUR CODER ET DECODER UN SYMBOLE D'INFORMATION

(84) Benannte Vertragsstaaten:
**AT BE CH CY DE DK ES FI FR GB GR IE IT LI LU MC NL PT SE TR**

(30) Priorität: **07.09.2000 DE 10044227**

(43) Veröffentlichungstag der Anmeldung:
**11.06.2003 Patentblatt 2003/24**

(73) Patentinhaber: **Nanotron Technologies GmbH 10555 Berlin (DE)**

(72) Erfinder:
• **Koslar, Manfred
14199 BERLIN (DE)**

• **HACH, Rainer
10589 Berlin (DE)**

(74) Vertreter: **Eckey, Ludger, Dr. et al
Eisenführ, Speiser & Partner
Anna-Louisa-Karsch-Strasse 2
10178 Berlin (DE)**

(56) Entgegenhaltungen:
EP-A- 0 555 013          DE-A- 4 440 947
DE-C- 19 912 825        US-A- 5 159 610
US-A- 5 455 839          US-A- 5 570 388

**Beschreibung**

Die vorliegende Erfindung bezieht sich auf Verfahren zum Codieren und Decodieren eines über einen Übertragungskanal zu übertragenden Informationssymbols oder Informationssymbolstroms. Ferner bezieht sich die Erfindung auf Vorrichtungen zum Codieren eines zu übertragenden Signals und Decodieren eines empfangenen Signalwerts.

Auf Übertragungskanälen ist im allgemeinen mit Echos, Mehrwegeausbreitung, Vor- und Nachschwingen zu rechnen. Diese Effekte führen zu Intersymbolinterferenz (ISI) zwischen zeitlich aufeinanderfolgenden Symbolen. Im allgemeinen Fall ist es nicht möglich, die Übertragungsfunktion des Übertragungskanals zu invertieren und dadurch den störenden Einfluss des Übertragungskanals zu eliminieren.

Es ist bekannt, dass der störende Einfluss des Übertragungskanals durch Vorrichtungen auf der Empfängerseite wie Equalizer oder Maximum Likelihood Sequence Estimation reduziert werden kann.

Auf der Senderseite eines Übertragungssystems stellt Precoding eine Möglichkeit zur Verringerung des störenden Einflusses der ISI dar, die durch den Übertragungskanal verursacht wird. Basierend auf dem durch M. Tomlinson in "New Automatic Equaliser Employing Modulo Arithmetic," Electronics Letters, 25th March 1971, Vol. 7, pp. 138-139 beschriebenen Tomlinson-Verfahren sind zahlreiche Untersuchungen zum Thema Precoding durchgeführt und diverse Precodingvarianten entwickelt worden.

Sowohl das Tomlinson-Verfahren wie auch alle anderen bekannten Precodingvarianten benötigen jedoch auf der Empfängerseite einen gewissen Rechenaufwand in Form von Operationen, die an das senderseitige Precoding angepasst sind.

Es ist daher Aufgabe der Erfindung, ein Verfahren und eine Vorrichtung zur Codierung bzw. Decodierung von Informationssignalen bereitzustellen, durch die der erforderliche Rechenaufwand insbesondere auf der Empfängerseite verringert werden kann.

Diese Aufgabe wird gelöst durch ein Verfahren gemäß Patentanspruch 1 bzw. 21 und durch eine Vorrichtung gemäß Patentanspruch 25 bzw. 29.

Erfindungsgemäß kann eine stabile Übertragung vorverzerrter Symbolströme über stark reflektionsbehaftete Übertragungskanäle bei geringem empfangsseitigen Rechenaufwand erreicht werden. Dazu wird ein Kanalsymbolalphabet definiert, das mächtiger ist, also mehr Elemente enthält als das Alphabet der zu übertragenden Informationssymbole (Informationssymbolalphabet). Auf Grund der Tatsache, dass das Kanalsymbolalphabet gegenüber dem Informationssymbolalphabet mächtiger ist, ergeben sich Wahlmöglichkeiten in der Form, dass ein Informationssymbol mittels unterschiedlicher Kanalsymbole übertragen werden kann . Deshalb wird das hier vorgeschlagene Codier- oder Precodingverfahren im folgenden als Multiple-Choice-Precoding (MCP) bezeichnet. Die erwähnte Wahlmöglichkeit wird derart genutzt, dass auf der Senderseite ein Sendewert mit möglichst wenig Energie gesendet wird, während die dadurch verursachte ISI minimal störend oder sogar konstruktiv wirkt.

Gegenüber bekannten Precodingverfahren besteht der Vorteil von MCP in der Tatsache, dass auf Empfängerseite keine zusätzlichen Rechenoperationen benötigt werden. Daher sind nicht nur die Kosten sondern auch eine etwaige Zeitverzögerung und Fehlerquellen wie Quantisierungsfehler oder Parameterungenauigkeiten verringert. Quasi als Nebeneffekt kann MCP bei konstanten Symbolfolgen die Funktion eines Scramblers (s. Lochmann: Digitale Nachrichtentechnik, Verlag Technik GmbH, Berlin 1997, 2Aufl., ISBN 3-241-01184-6) übernehmen und erleichtert damit die bitfolgeunabhängige Symbolsynchronisation auf Empfängerseite bei hoher Datenrate.

Aus US 5,570,388 ist ein Verfahren einer Vorrichtung bekannt, bei der einfache Codes für die drahtlose Übertragung von Nichtdaten-Symbolen verwendet werden. In dieser Druckschrift wird ein "spare symbol" definiert, das im Gegensatz zur vorliegenden Erfindung jedoch keine Informationen trägt, sondern eine Delimiter-Funktion erfüllt.

Aus DE 199 12 825 ist ein Verfahren einer Empfangseinrichtung einer Funkstation zum Detektieren eines Datensymbols bekannt. Eine gewisse Übereinstimmung mit der vorliegenden Erfindung liegt darin, dass Abstände zu Konstellationspunkten - bei der vorliegenden Erfindung zu Konstellationsbereichen - ermittelt und berücksichtigt werden. Im Unterschied zur vorliegenden Erfindung finden jedoch alle Berechnungen auf der Empfängerseite und nicht wie bei der vorliegenden Erfindung auf der Senderseite statt. Bei dem Ziel, die Empfängerseite so einfach wie möglich zu gestalten, wird das, was in DE 199 12 825 gelehrt wird, gerade nicht erreicht.

Aus DE 198 24 408 ist ein Empfänger für ein digitales Übertragungssystem bekannt, wobei auch hier wie in DE 199 12 825 vorgesehen ist, dass empfängerseitig ein spezieller Entzerrer vorgesehen ist, mittels dem die notwendigen Berechnungen vorgenommen werden.

Aus DE 44 40 947 ist ein Verfahren zur digitalen Nachrichtenübertragung bekannt. Diese Druckschrift nimmt engen Bezug auf das Tomlinson-Harashima-Verfahren und beschreibt eine Weiterentwicklung desselben. In der Druckschrift geht es ganz allgemein um die Verringerung der empfangsseitigen Signaldynamik. Ein wichtiger Unterschied zwischen dem, was in DE 44 40 947 offenbart ist und der vorliegenden Erfindung besteht darin, dass bei dem Tomlinson-Harashima-Verfahren als auch nach DE 44 40 947 eine Modulo-N-Operation bezüglich der Signalamplitude auf der Empfängerseite nötig ist. Wie in DE 44 40 947 weiterhin gezeigt, existieren bei dem Tomlinson-Harashima-Verfahren durch die periodische Fortsetzung der Amplitudenkonstellation auf einer reellwertigen Achse ohnehin nicht viele Signalwerte zur Repräsentation eines Signalsymbols bzw. viele Signalwerte zur Repräsentation eines Sendersymbols nach DE 44 40 947.

Bei der vorliegenden Erfindung wird im Unterschied dazu jedoch grundsätzlich eine komplexe Ebene benutzt. In dem in der vorliegenden Anmeldung aufgeführten Ausführungsbeispiel unterscheidet sich das Kanalsymbolalphabet gegenüber dem Informationssymbolalphabet auch in der Anzahl der möglichen Phasenwerte seiner Elemente. Durch die unmittelbare Nutzung der komplexen Ebene tritt bei der vorliegenden Erfindung das Problem der erhöhten empfangsseitigen Signaldynamik nicht auf und eine wie beim Tomlinson-Harashima-Verfahren unendliche, absehbare Menge von "Sendewerten" wird nicht benötigt.

Vorzugsweise wird durch die Kanaleigenschaften und durch die in der Vergangenheit gesendeten Sendewerte die Position einer Unsicherheitsregion und durch die zukünftig zu sendenden Sendewerte die Form und Grösse dieser Unsicherheitsregion in der komplexen Ebene definiert. Die Position der Unsicherheitsregion wird durch einen ISI-Anteil $E^{ISIpost}$ bestimmt, der mittels der Kanaleigenschaften und den in der Vergangenheit gesendeten Sendewerten exakt vorausberechenbar ist. Ein weiterer ISI-Anteil $E^{ISIpre}$, der durch zukünftige Sendewerte im Zusammenwirken mit den Kanaleigenschaften entstehen wird, kann aus Kausalitätsgründen nicht exakt vorausberechnet werden. Die Form und Größe der Unsicherheitsregion berücksichtigen jedoch den möglichen Einfluss den $E^{ISIpre}$ bei der Detektion des aktuell zu übertragendenSignals haben könnte. Die senderseitige Auswahl des wählbaren, auf Empfängerseite angestrebten Kanalsymbols erfolgt basierend auf dessen Lage in Bezug auf die aktuell berechnete Unsicherheitsregion.

Die Kanaleigenschaften, insbesondere das Vor- und Nachschwingverhalten des Übertragungskanals, kann vorzugsweise anhand der Kanalimpulsantwort ermittelt werden. Die Kanalimpulsantwort kann beispielsweise messtechnisch erfasst und in vorbestimmten Zeitabständen aktualisiert werden.

Gemäß einer vorteilhaften Ausgestaltung kann das Kanalsymbol ausgewählt werden, welches von allen wählbaren Kanalsymbolen in der komplexen Ebene den geringsten Abstand und damit den kleinsten Korrekturwert bezüglich des von ihm aus am weitesten entfernten Punkt der Unsicherheitsregion aufweist. Dieser "minimale Maximalwert" wird im Folgenden als "kleinster Korrekturwert" bezeichnet. Durch dieses Auswahlkriterium ist bei gleichzeitiger Minimierung der Energie des Sendewerts eine hohe Wahrscheinlichkeit der richtigen empfangsseitigen Entscheidung bezüglich des im Empfangswert enthaltenen Kanalsymbols sichergestellt.

Gemäß einer weiteren vorteilhaften Ausgestaltung, kann der Sendewert "0" (physikalisch wird nichts gesendet) auftreten, falls sich die aktuell berechnete Unsicherheitsregion in einem Bereich befindet, der mit hoher Wahrscheinlichkeit auf der Empfängerseite zu einer Entscheidung für ein Kanalsymbol führt, das für die Übertragung des aktuellen Informationssymbols wählbar ist. Dies bedeutet, dass die von vergangenen Sendewerten verursachte ISI konstruktiv wirkt und ausreicht, um das für das gegenwärtige Informationssymbol gewählte Kanalsymbol zu übertragen.

Vorzugsweise kann eine Bereichsbegrenzung des Sendewerts derart durchgeführt werden, dass die komplexen Komponenten eines gesendeten Sendewerts jeweils auf einen Maximalwert begrenzt werden. Dies führt zu einer Begrenzung der Sendeenergie.

Als bei der Decodierung verwendeter Abstand kann vorzugsweise ein euklidischer Abstand oder eine Hamming-Distanz berechnet werden. Diese Größen liefern ein Maß für die Entscheidungsdistanz zwischen verschiedenen wählbaren Kanalsymbolen.

Gemäß einer weiteren vorteilhaften Ausgestaltung kann die in der Codierungsvorrichtung vorgesehene Berechnungseinrichtung umfassen eine erste Speichereinrichtung zum Speichern der bereits gesendeten Sendewerte, eine zweite Speichereinrichtung zum Speichern von das Nachschwingen des Übertragungskanals beschreibenden Kanalkoeffizienten, eine Multiplikationseinrichtung zum Multiplizieren der bereits gesendeten Sendewerte mit den zugehörigen Kanalkoeffizienten, und eine Additionseinrichtung zum Aufaddieren der Multiplikationsergebnisse. Durch fortlaufendes Speichern der bereits gesendeten Sendewerte in der ersten Speichereinrichtung und zeitweises Aktualisieren der Kanalkoeffizienten in der zweiten Speichereinrichtung ist eine einfache Anpassung des Codierers an die aktuelle Übertragungssituation bei geringem Rechenaufwand möglich. Die erwarteten Empfangssignalwerte können dann in der Berechnungseinrichtung vorzugsweise anhand des Additionsergebnisses, des ausgewählten Kanalsymbols und eines das Vorschwingverhalten des Übertragungskanals berücksichtigenden Erwartungswerts vorausberechnet werden. Dies ermöglicht eine Berücksichtigung des Vorschwingverhaltens des Übertragungskanals. Zur Verringerung der durch das Vorschwingverhalten hervorgerufenen ISI kann zudem ein an den Übertragungskanal adaptiertes Vorfilter vorgesehen sein.

Die Erfindung wird nachfolgend anhand eines bevorzugten Ausführungsbeispiels unter Bezugnahme auf die beiliegenden Zeichnungsfiguren näher erläutert. Es zeigen:

Fig. 1    ein prinzipielles Blockschaltbild eines Übertragungssystems gemäß dem bevorzugten Ausführungsbeispiel,

Fig. 2    ein prinzipielles Blockschaltbild eines Codierers gemäß dem bevorzugten Ausführungsbeispiel,

Fig. 3            ein prinzipielles Flußdiagramm eines Codierverfahrens gemäß dem bevorzugten Ausführungsbeispiel,

Fig. 4A-4C      beispielhafte Darstellungen des kleinsten Korrekturwerts und des berechneten Sendewerts für eine in dem bevorzugten Ausführungsbeispiel erläuterte Fallunterscheidung,

Fig. 5            ein prinzipielles Flußdiagramm eines Decodierverfahrens gemäß dem bevorzugten Ausführungsbeispiel,

Fig. 6            eine Darstellung zur Erläuterung einer bei der Decodierung herangezogenen Entscheidungsdistanz,

Fig. 7            ein Diagramm zur Darstellung von bei einer BPSK-Codierung verwendeten Entscheidungsregionen,

Fig. 8            eine beispielhafte komplexe Impulsantwort eines Übertragungskanals,

Fig. 9            ein komplexes Diagramm zur Darstellung der Konstellation eines am Empfängereingang vorliegenden BPSK-Symbolstroms ohne Verwendung der erfindungsgemäßen Codierung,

Fig. 10          ein komplexes Diagramm zur Darstellung der Konstellation eines am Empfängereingang vorliegenden BPSK-Symbolstroms bei Verwendung der erfindungsgemäßen Codierung,

Fig. 11          ein komplexes Diagramm zur Darstellung der Konstellation am Empfängereingang bei einer konstanten Folge gleicher Informationssymbole unter Verwendung der erfindungsgemäßen Codierung, und

Fig. 12          ein Flussdiagramm zur Darstellung der Berechnung eines Sendewertes im vorausschauenden MCP.

Im Folgenden wird das bevorzugte Ausführungsbeispiel zunächst in allgemeiner Form und danach am speziellen Beispiel einer BPSK-Modulation erläutert.

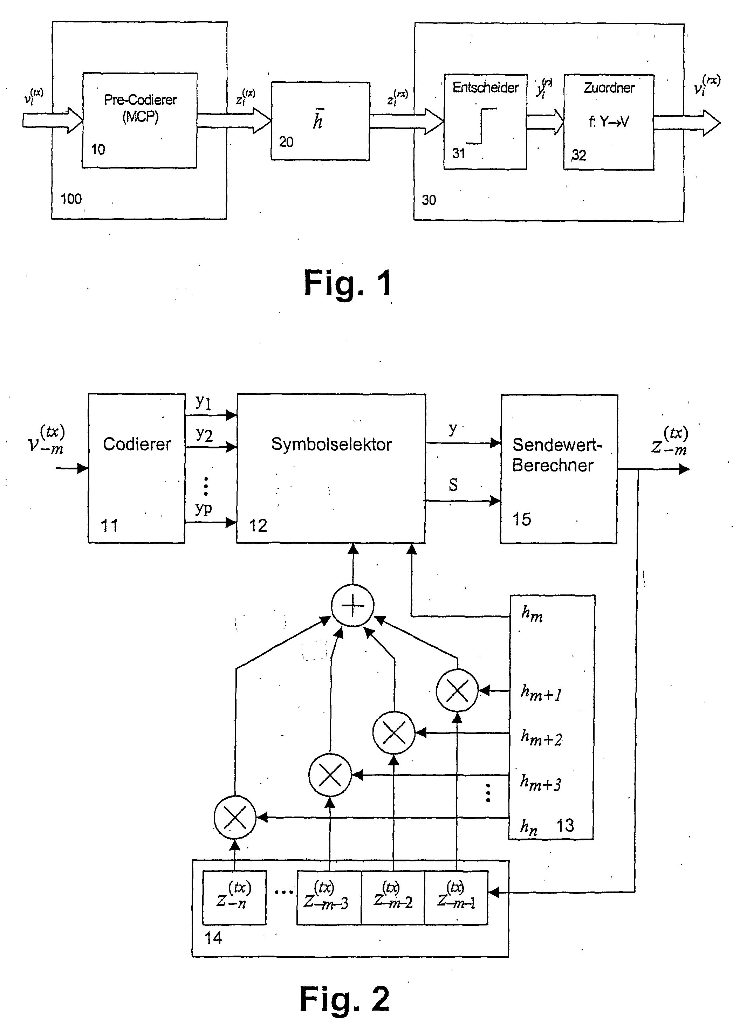

Fig. 1 zeigt ein prinzipielles Blockschaltbild des Symbolflusses in einem Basisbandmodell bei einer Übertragung von Informationssymbolen unter Verwendung mehrerer wählbarer Kanalsymbole (MCP-Verfahren). Gemäß K. D. Kammayer, "Nachrichtenübertragung", B.G. Teubner-Verlag Stuttgart, 2. Auflage, ISBN 3-519-16142-7 werden hier durch Blockpfeile komplexwertige Signale gekennzeichnet. Signale, Symbole und Werte auf Senderseite sind grundsätzlich mit einem $^{(tx)}$, Signale, Symbole und Werte auf Empfängerseite mit einem $^{(rx)}$ gekennzeichnet. Als diskreter Zeitindex wird der Index i verwendet. Für ein zum Zeitpunkt i am Sendereingang anliegendes Informationssymbol $v_i^{(tx)} \in V$ wählt der Pre-Codierer ($f^{MCP}(\cdot)$) 10 ein am Empfängereingang anzustrebendes Kanalsymbol und berechnet daraus einen auszusendenden Sendewert $z_i^{(tx)} \in Z^{(tx)}$. Bei dieser Berechnung werden sowohl die Kanaleigenschaften als auch die in der Vergangenheit gesendeten Sendewerte berücksichtigt. Es gilt:

$$z_i^{(tx)} = f^{MCP}(v_i^{(tx)}, \bar{h}, z_{i-1}^{(tx)}, z_{i-2}^{(tx)}, ..., z_{i-n}^{(tx)}), \qquad (1)$$

wobei n der Gedächtnistiefe eines zur Übertragung verwendeten Kanals 20 mit der Charakteristik $\bar{h}' = [h_0, h_1, ... h_n]$, mit $h_0, h_n \neq 0$ und damit der Kanalordnung entspricht.

Der in einem Pre-Codierer 10 eines Senders 100 nach dem MCP-Verfahren erzeugte Sendewert $z_i^{(tx)}$ wird über den Kanal 20 gesendet. Aus dem nach einer Zeitverzögerung am Eingang eines Empfängers 30 eintreffenden Empfangswert $z_i^{(rx)}$ wird mittels eines Entscheiders 31 das zugrunde liegende Kanalsymbol $y_i^{(rx)}$ ermittelt.

Aus diesem Kanalsymbol $y_i^{(rx)}$ wird mittels eines Zuordners 32 unter Verwendung einer Mappingfunktion $f(\cdot)$, die eine einfache eindeutige jedoch nicht umkehrbare

Abbildung ist, ein empfangenes Informationssymbbl $v_i^{(rx)}$ detektiert oder ermittelt.

Für diesen Detektionsvorgang wird ein Detektionsfehler $D^{err}(z^{(rx)}, y^{(rx)}, v^{(tx)})$ gemäß der nachfolgenden Gleichung (2) definiert, der auf der Senderseite vorausberechenbar ist. $D^{err}(\cdot)$ ist abhängig von dem vorausberechneten, am Entscheidereingang liegenden Empfangswert $z^{(rx)}$, dem daraus detektierten Kanalsymbol $y^{(rx)}$ und dem gewünschten Informationssymbol $v^{(tx)}$, das am Empfängerausgang erscheinen soll:

$$D^{err}(z^{(rx)}, y^{(rx)}, v^{(tx)}) := \begin{cases} -1 \cdot BordDist\,(z^{(rx)}, y^{(rx)}) & wenn\ f(y^{(rx)}) = v^{(tx)} \\ BordDist\,(z^{(rx)}, y^{(rx)}) & wenn\ f(y^{(rx)}) \neq v^{(tx)} \end{cases} \qquad (2)$$

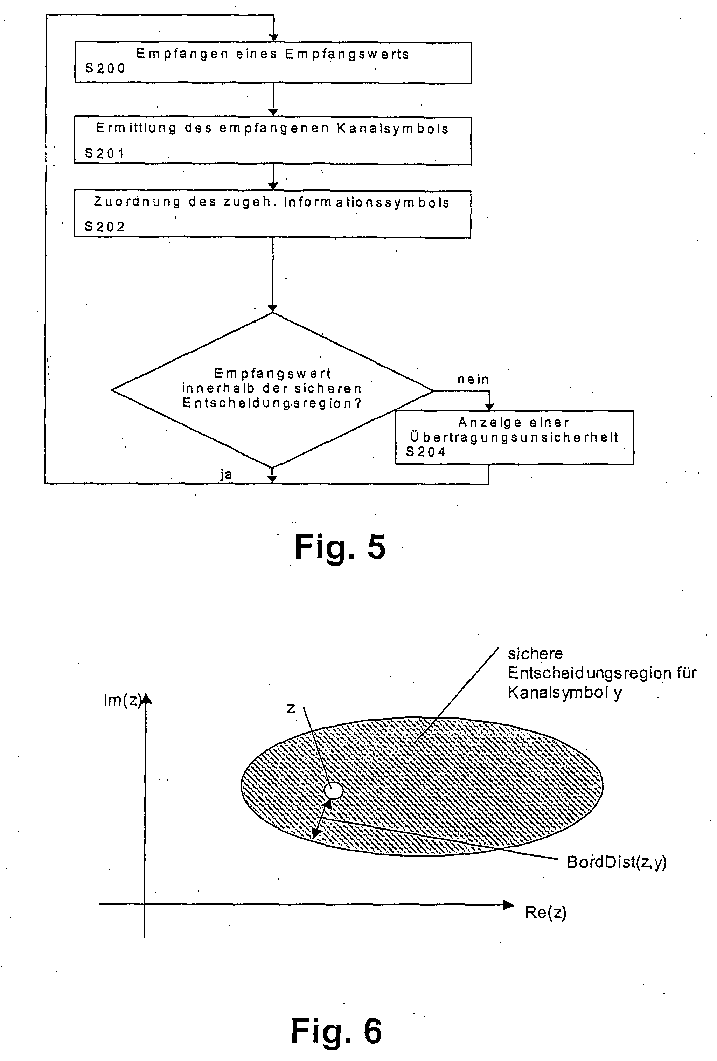

Die Funktion *BordDist* (z,y) liefert die Entscheidungsdistanz (s. Fig. 6). Gemeint ist damit der euklidische Abstand zwischen dem Wert z und der Grenze der sicheren Entscheidungsregion des durch den Entscheider 31 detektierten Kanalsymbols y. Als Entscheidungsdistanz kann auch die Hammingdistanz oder eine andere geeignete Größe verwendet werden.

Bei dem Detektionsfehler $D^{err}(z^{(rx)}, y^{(rx)}, v^{(tx)})$ handelt es sich also um ein Maß für die Unsicherheit, mit der bei einem gegebenen Empfangssymbol $z^{(rx)}$ ein Informationssymbol $v^{(tx)}$ richtig detektiert wird. Je kleiner der Detektionsfehler ist, desto sicherer ist die Detektion. Ein negativer Detektionsfehler signalisiert, dass das Empfangssymbol $z^{(rx)}$ innerhalb der sicheren Entscheidungsregion eines Kanalsymbols, $y^{(rx)}$ liegt und dass dieses Kanalsymbol auf das richtige Informationssymbol abgebildet wird.

Gemäß dem bevorzugten Ausführungsbeispiel wird auf der Senderseite vorausberechnet, in welchem Bereich der Empfangswert liegen wird, den der Empfänger auf Grund des nun zu bestimmenden Sendewerts später erfassen wird. Dazu ist senderseitig sowohl die Kenntnis des Kanals $\bar{h}$ als auch sämtlicher Synchronisations-, Filter- und Detektionsoperationen, die auf Empfängerseite durchgeführt werden, notwendig. Dabei kann vorzugsweise angenommen werden, dass der Empfänger eine symbolweise Detektion durchführt, dass ein Empfangswert gegenüber seinem Sendezeitpunkt mit einer Zeitverzögerung von m Symbolzeitschritten abgetastet (gesampelt) wird, nach der er sich im Betragsmaximum der Kanalimpulsantwort befindet, und dass der Empfänger 30 eine Phasensynchronisation derart vornimmt, dass der zum Zeitpunkt m gesampelte Empfangswert phasenrichtig vorliegt. In einem verzerrungsfreien System, in dem der Kanal 20 die Zeitverzögerung m und kein Vorschwingen und Nachschwingen aufweist, würde für die erfassten Empfangswerte die folgende Gleichung (3) gelten:

$$z_i^{(rx)} = \sum_{k=0}^{n} h_k \cdot z_{i-k}^{(tx)} = \sum_{k=0}^{n} \delta_{k,m} \cdot z_{i-k}^{(tx)} = z_{i-m}^{(tx)}\,, \qquad (3)$$

wobei $\delta_{i,j}$ das Kroneckersymbol bezeichnet. Der nach m Symbolzeitschritten empfangene Empfangswert würde also erwartungsgemäß dem gesendeten Sendewert entsprechen. Dem gegenüber wird in einem realen System der Empfangswert $z^{(rx)}$ auf Grund der Kanaleigenschaften Störanteile von zeitlich benachbarten Symbolen sowie additives Rauschen enthalten.

Um das Vor- und Nachschwingen der Kanalimpulsantwort zu berücksichtigen, wird angenommen, dass die effektive Kanalimpulsantwort des zwischen dem Sender 100 und dem Empfänger 30 liegenden Kanals 20 die folgende Charakteristik aufweist:

$$|h_0|, |h_1|, \ldots |h_{m-1}| < 1,\ h_m = 1,\ |h_{m+1}|, |h_{m+2}|, \ldots |h_n| \leq 1 \qquad (4)$$

wobei die Koeffizienten $h_0, h_1, \ldots h_{m-1}$ das Vorschwingen und die Koeffizienten $h_{m+1}, h_{m+2}, \ldots h_n$ das Nachschwingen der Kanalimpulsantwort beschreiben. Auf Grund der Verzögerung m gilt für den zum Zeitpunkt i=0 am Empfängereingang erfassten Empfangswert $z_0^{(rx)}$:

$$(h_n \quad \ldots \quad h_{m+2} \quad h_{m+1}) \cdot \begin{pmatrix} z_{-n}^{(tx)} \\ \cdot \\ z_{-m-1}^{(tx)} \end{pmatrix} + z_{-m}^{(tx)} + (h_{m-1} \quad \ldots \quad h_1 \quad h_0) \cdot \begin{pmatrix} z_{-m+1}^{(tx)} \\ \cdot \\ z_0^{(tx)} \end{pmatrix} = z_0^{(rx)} \qquad (5)$$

Der erste Summand der linken Seite in Gleichung (5) beschreibt dabei ISI-Anteile $E^{ISIpost}$, die durch Sendewerte beschrieben werden können, welche zeitlich vor dem Sendewert $z^{(tx)}$ gesendet wurden und auf das Nachschwingen (post-cursor) des Kanals zurückzuführen sind, während der letzte Summand die ISI Anteile $E^{ISIpre}$ beschreibt, die durch Vorschwingen (pre-cursor) verursacht werden und von Sendewerten abhängen, die zeitlich nach dem Sendewert $z^{(tx)}$ gesendet wurden und demzufolge noch nicht bekannt waren, als der Sendewert $z^{(tx)}_{-m}$ gesendet wurde. Dies lässt sich durch die folgende Gleichung (6) darstellen:

$$E_0^{ISIpost} + z_{-m}^{(tx)} + E_0^{ISIpre} = z_0^{(rx)} = y_0^{(rx)} + Error \tag{6}$$

Der rechte Teil der Gleichung (6) zeigt, dass der Empfangswert als Summe aus einem übertragenen Kanalsymbol und einem durch Störungen verursachten Fehlerwert interpretiert werden kann.

Zur Berücksichtigung des Vorschwingens des Kanals 20 legt man für den Erwartungswert, $E\{\cdot\}$, des Betrages der Sendesymbole einen oberen Grenzwert K fest, so daß gilt: $E\{|z^{(tx)}|\} \leq K$. Somit lässt sich $E_0^{ISIpre}$ nach oben abschätzen. Mit der Gleichung:

$$d = K \cdot \sum_{i=0}^{m-1} |h_i| \tag{7}$$

erhält man mit der Definition ($A \Rightarrow B : A$ impliziert $B$):

$$\left|E_0^{ISIpre}\right| \leq d \Rightarrow \left|real(E_0^{ISIpre})\right| \leq d, \ \left|imag(E_0^{ISIpre})\right| \leq d, \tag{8}$$

wobei in den folgenden Ausführungen $K = 1$ angenommen wird. Während die linke Seite der Gleichung (8) eine Kreisscheibe in der komplexen Ebene darstellt, beschreibt die rechte Seite der Gleichung (8) ein Quadrat, das diese Kreisscheibe enthält und mit dem aus Vereinfachungsgründen weitergerechnet wird.

Der zum Zeitpunkt i=0 erfasste Empfangswert $z_0^{(rx)}$ war also zum Zeitpunkt i=-m nicht im voraus als Punkt in der komplexen Ebene exakt lokalisierbar. Daher wird gemäß der nachfolgenden Gleichung (9) eine quadratische Region $S^{(rx)}(z)$ definiert, innerhalb der der Empfangswert erwartet wird:

$$S^{(rx)}(E_0^{ISIpost}+z_{-m}^{(tx)})=E_0^{ISIpost}+z_{-m}^{(tx)}\pm d\pm j \cdot d \tag{9}$$

Die Region:

$$S^{(rx)}(E_0^{ISIpost}) \tag{9a}$$

wird im folgenden als Unsicherheitsregion zum Zeitpunkt i=0 definiert. Sie bezeichnet den Bereich, in dem die zum Zeitpunkt i=0 am Empfängereingang auftretende ISI mit hoher Wahrscheinlichkeit liegen muss. Dem zufolge beschreibt die Region $S^{(rx)}(E_0^{ISIpost} + z_{-m}^{(tx)})$ den Bereich, in dem der Empfangswert $z_0^{(rx)}$ mit hoher Wahrscheinlichkeit liegen muss. Die Größe der Unsicherheitsregion $S^{(rx)}(E^{ISIpost})$ hängt vom Vorschwingverhalten (Anschwingverhalten) des Kanals 20 ab. Berücksichtigt man noch die allgemeine Forderung, dass um etwaige Übersteuerungsverzerrungen klein zu halten, möglichst wenig Symbolenergie gesendet werden soll, so mündet die Berechnung von $z_{-m}^{(tx)}$ in das folgende Optimierungsproblem:

Finde das $z_{-m}^{(tx)} = z_{opt}$, das möglichst wenig Sendeenergie benötigt, d.h.

$$z_{opt} = \min(|z|^2), \tag{10a}$$

unter den Nebenbedingungen, dass $z$ in der Menge der möglichen Sendesymbole enthalten ist, d.h.

$$z \in Z^{(tx)} \tag{10b}$$

und dass für alle $z_0^{(rx)} \in S_0^{(rx)}(E_0^{ISIpost} + z)$ zu einer richtigen Detektion des Informationssymbols am Empfänger 30 führt, d.h.

$$D^{err}(S_0^{(rx)}(E_0^{ISIpost} + z), y_0^{(rx)}, v_{-m}^{(tx)}) < 0 \tag{10c}$$

Es handelt sich also um ein nichtlineares, restringiertes Optimierungsproblem. Ohne einen analytischen Nachweis der Lösbarkeit dieses Optimierungsproblems erbracht zu haben, wird im folgenden ein einfach realisierbares Ausführungsbeispiels angegeben, das das oben definierte Optimierungsproblem zumindest näherungsweise löst.

Die in dem Pre-Codierer 10 bereitgestellte Pre-Codierer-Funktion kann nach Ermittlung der Kanaleigenschaft in Form einer Wertetabelle realisiert werden. Die Wertetabelle kann dabei beispielsweise als Wertetabelle für wahrscheinliche Typen von Kanalimpulsantworten realisiert sein, wobei dann eine Auswahl anhand der gemessenen Kanaleigenschaft erfolgen kann.

Fig. 2 zeigt ein prinzipielles Blockschaltbild des Pre-Codierers 10 gemäß dem bevorzugten Ausführungsbeispiel, wobei die in Gleichung (5) angegebenen Indices für die Kennzeichnung der zeitlichen Reihenfolge verwendet werden. Das zu übertragende Informationssymbol $v_{-m}^{(tx)}$ wird einem Codierer 11 zugeführt, der die für $v_{-m}^{(tx)}$ wählbaren p Kanalsymbole $y_1$ bis $y_p$ erzeugt und einem Symbolselektor 12 zuführt. Der Codierer 11 kann durch eine Speichertabelle oder dergleichen realisiert werden. Des weiteren ist ein als parallel auslesbares Schieberegister aufgebauter Symbolspeicher 14 vorgesehen, in den die bereits gesendeten Sendewerte $z_{-m-1}^{(tx)}$ bis $z_{-n}^{(tx)}$ beim jeweiligen Senden jeweils aufeinanderfolgend eingeschrieben werden. Die Anzahl n-m der gespeicherten Sendewerte entspricht dabei der Nachschwingdauer des Kanals 20. Ein ebenfalls parallel auslesbarer Koeffizientenspeicher 13 dient zum Speichern der Koeffizienten $h_m$ bis $h_n$ des Kanals 20, wobei der Koeffizient $h_m$ dem Symbolselektor 12 zur Berücksichtigung der direkten Wirkung des Kanals 20 auf das zu übertragende Informationssymbol $v_{-m}^{(tx)}$ zugeführt wird.

Entsprechend einer diskreten Faltung werden die Kanalkoeffizienten $h_j$ mit den zugehörigen gespeicherten Sendewerten $z_{-j}$ in entsprechenden Multiplikationseinrichtungen multipliziert und in einer Additionseinrichtung aufaddiert, um dadurch einen für das aktuelle Nachschwingen des Kanals 20 charakteristischen Wert zu erhalten, der dem Symbolselektor 12 zugeführt und zur Berechnung der für die Auswahl des geeigneten Kanalsymbols herangezogenen erwarteten Empfangswerte oder - wertebereichs (d.h. der Unsicherheitsregion S) verwendet wird.

Das vom Symbolselektor 12 selektierte Kanalsymbol y und die im Symbolselektor berechnete Unsicherheitsregion $S^{(rx)}(E^{ISIpost})$ werden von einem Sendewertberechner 15 zur Berechnung des aktuellen Sendewerts $z_{-m}^{(tx)}$ gemäß der nachfolgenden Beschreibung herangezogen.

Die in Fig. 2 gezeigten Blöcke können selbstverständlich auch als Programmroutinen für einen in dem Sender 100 vorgesehenen Signalprozessor odgl. realisiert sein.

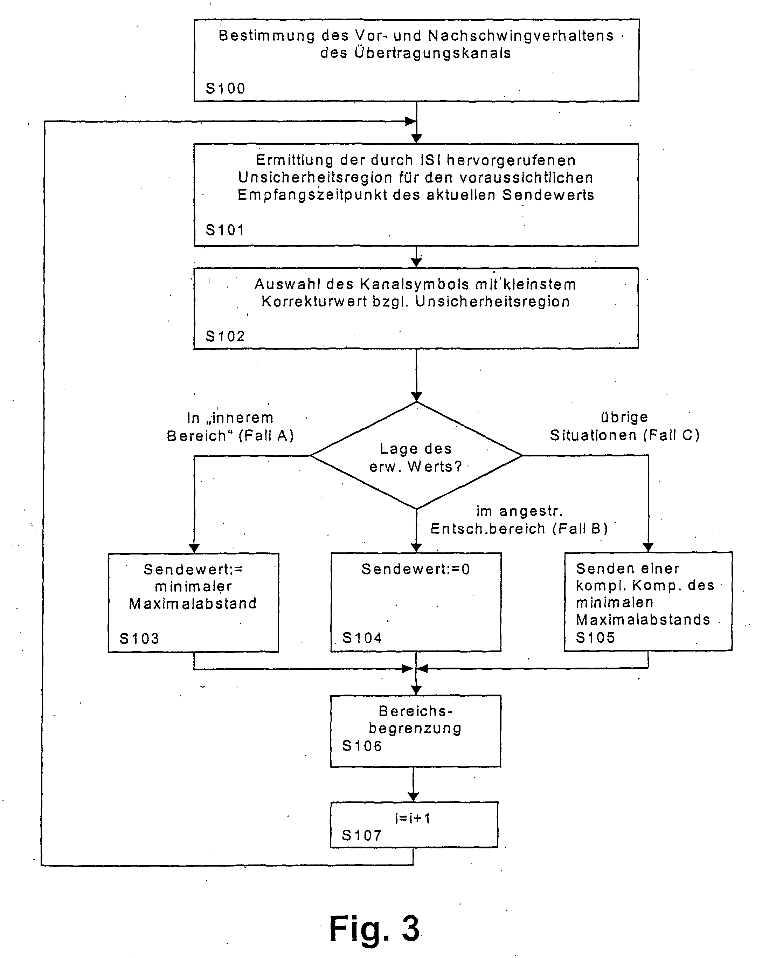

Fig. 3 zeigt ein prinzipielles Flußdiagramm des Codierverfahrens gemäß dem bevorzugten Ausführungsbeispiel.

Im Schritt S100 wird zunächst das Vor- und Nachschwingverhalten des Kanals 20 beispielsweise anhand einer gemessenen Kanalimpulsantwort $\bar{h}$ des Kanals 20 ermittelt und die entsprechenden Koeffizienten gespeichert. Zum Zeitpunkt i sind das zu übertragende Informationssymbol $v_i^{(tx)}$ und die in dem Symbolspeicher 14 gespeicherten vergangenen Sendesymbole $z_{i-1}^{(tx)}, z_{i-2}^{(tx)}, \ldots z_{i-n+m}^{(tx)}$ bekannt, wobei n die Kanal-ordnung und m die Kanalverzögerung angeben.

Der zum Zeitpunkt i zu emittierende Sendewert $z_i^{(tx)}$ wird in folgender Weise ermittelt. Im Schritt S101 wird die durch die ISI hervorgerufenen Unsicherheitsregion für den Empfang am Empfänger 30 zum Zeitpunkt i+m gemäß der Gleichung (9a) berechnet. Dies kann beispielsweise durch Berechnung der Eckpunkte der Unsicherheitsregion $S^{(rx)}(E_{i+m}^{ISIpost})$ erfolgen. Danach wird im Schritt S102 das der Unsicherheitsregion am nächsten liegende Kanalsymbol ermittelt. Dies kann beispielsweise dadurch erfolgen, daß für jedes für $v_i^{(tx)}$ in Frage kommende Kanalsymbol $y_j$, j = 1,..p derjenige Differenzwert zwischen Kanalsymbol und Eckpunkt der Unsicherheitsregion S, dessen Betrag maximal ist, gemäß den folgenden Gleichungen (11a) und (11b) bestimmt wird. Bei einer Unsicherheitsregion mit den 4 Eckpunkten $(c_1, c_2, c_3, c_4)$ ergibt sich:

$$l_{\max} = \arg_l(\max(|y_j - c_l|)) \quad l = 1,2,3,4 \tag{11a}$$

(wobei die arg(max($f_l$))-Operation das Argument l liefern möge, bei dem $f_l$ maximal wird)

$$z^{(max)}(j)=y_j-c_{l_{max}} \qquad (11b)$$

Dabei wird jeweils das Kanalsymbol mit dem kleinsten Korrekturwert $z^{(diff)}$ als das anzustrebende Kanalsymbol $y^{(tx)}$ ausgewählt, das mit dem gesuchten Sendewert am Empfängereingang erzeugt werden soll, und der kleinste Korrekturwert $z^{(diff)}$ wird für weiter Rechenschritte zwischengespeichert. Also gilt:

$$j_{min} = \arg_j(\min(|z_j^{max}|)) \quad j=1,2,...p\,, \qquad (12a)$$

$$y^{(tx)} = y_{j_{min}}$$
$$z^{(diff)} = z^{(max)}(j_{min}) \qquad (12b)$$

Es erfolgt nun eine Fallunterscheidung hinsichtlich der Lage des erwarteten ISI-Anteils $E^{ISIpost}$.

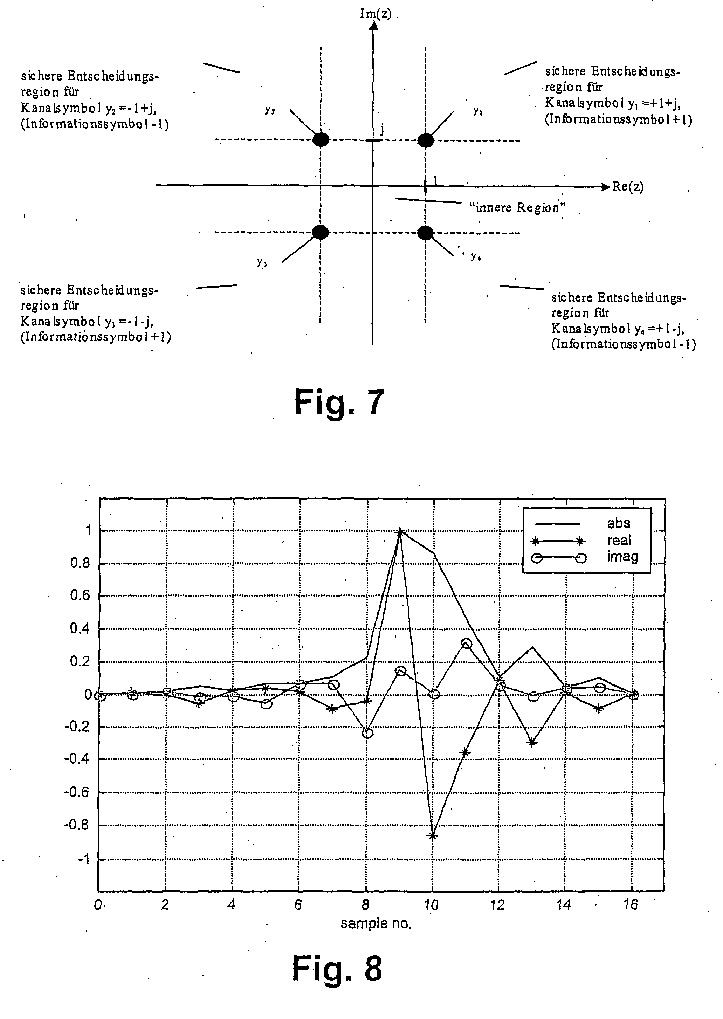

Befindet sich der erwartete ISI-Anteil $E_{i+m}^{ISIpost}$ in einem Fall A innerhalb des durch die Kanalsymbole aufgespannten "inneren Bereichs", wie beispielsweise das durch die vier Kanalsymbole einer konventionellen QPSK-Modulation aufgespannte Quadrat (s. Fig. 7), so wird der gemäß Gleichung (12b) ermittelte Sendewert $z^{(diff)}$ gesendet, um bei niedriger Sendeenergie und niedriger nachfolgender ISI eine sichere Detektion zu ermöglichen (S103). Im Fall A gilt somit:

$$\left|real(E_{i+m}^{ISIpost})\right|<1 \wedge \left|imag(E_{i+m}^{ISIpost})\right|<1 \rightarrow z_i^{(tx)}:=z^{(diff)} \qquad (13)$$

(mit der Definition $A \rightarrow B$ : wenn A dann B)

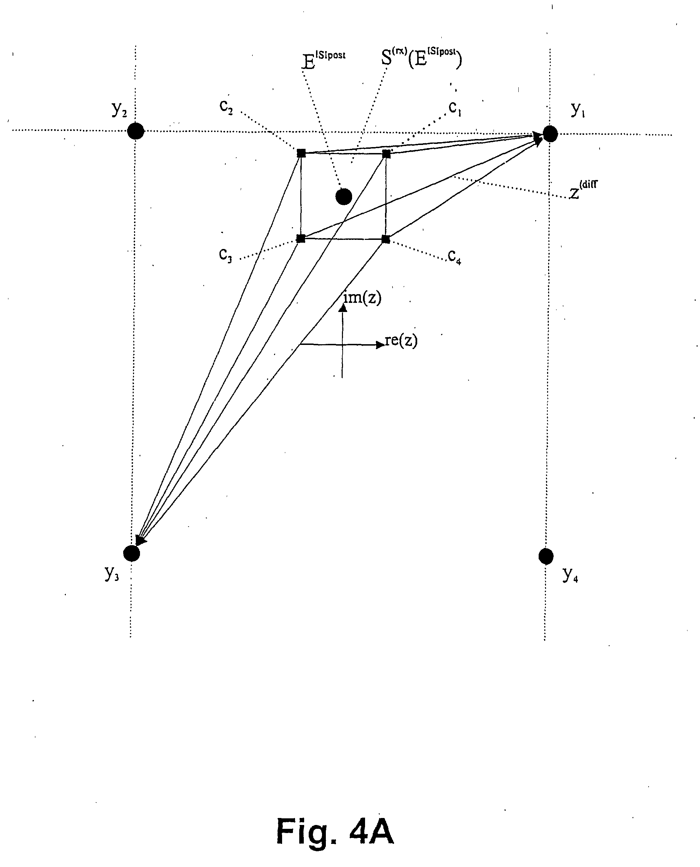

Fig. 4A zeigt eine dem Fall A entsprechende Konstellation für eine QPSK-Modulation, wobei das zu übertragende Informationssymbol $v^{(tx)}$ = +1 ist und die Kanalsymbole $y_1$ und $y_3$ wählbar sind. Die Unsicherheitsregion $S^{(rx)}(E_i^{ISIpost})$ befindet sich innerhalb des "inneren Bereichs" und der kleinste Korrekturwert $z^{(diff)}$ entspricht dem Abstand zwischen dem entferntesten Eckpunkt $c_3$ und dem auf Grund des geringsten maximalen Eckabstands gewählten Kanalsymbol $y_1$. Dieser kleinste Korrekturwert $z^{(diff)}$ wird dann als Sendewert zum Erzielen des gewünschten Empfangswerts gesendet.

Befindet sich der ISI-Anteil $E_{i+m}^{ISIpost}$ in einem Fall B dagegen bereits in der Entscheidungsregion des angestrebten Kanalsymbols, so wird der Sendewert "0" gesendet (S104), da keine Korrektur erforderlich ist. Im Fall B gilt also (mit der Definition $sign(x)$ : $Signum(x)$):

$$\left|real(E_{i+m}^{ISIpost})\right|\geq1 \wedge \left|imag(E_{i+m}^{ISIpost})\right|\geq1 \wedge$$
$$sign(real(E_{i+m}^{ISIpost}))=sign(real(y_{i+m}^{(rx)})) \wedge$$
$$sign(imag(E_{i+m}^{ISIpost}))=sign(imag(y_{i+m}^{(rx)}))$$
$$\rightarrow z_i^{(tx)}:=0 \qquad (14)$$

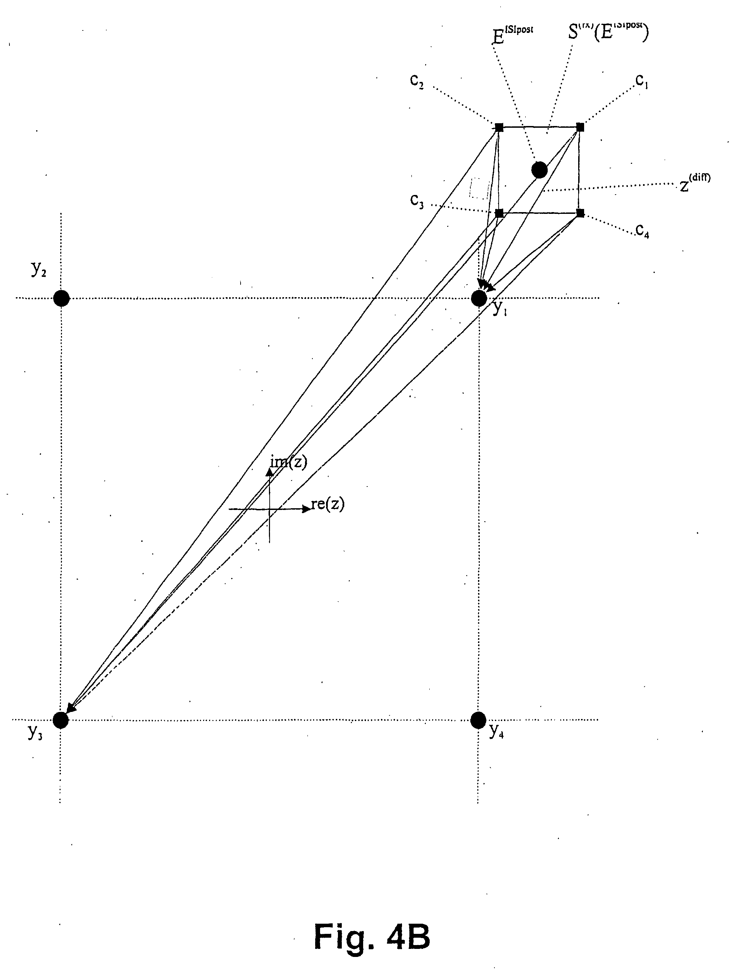

Fig. 4B zeigt eine dem Fall B entsprechende Konstellation für eine QPSK-Modulation, wobei auch hier das zu übertragende Informationssymbol $v^{(tx)}$ = +1 ist und somit die Kanalsymbole $y_1$ und $y_3$ wählbar sind. Die Unsicherheitsregion $S^{(rx)}(E^{ISIpost})$ befindet sich bereits ohne Korrekturwert innerhalb des für das Informationssymbol $v^{(tx)}$ = +1 festgelegten Entscheidungsbereichs gemäß Gleichung (14). Der kleinste Korrekturwert $z^{(diff)}$ entspricht dem Abstand zwischen dem entferntesten Eckpunkt $c_1$ und dem auf Grund des geringsten maximalen Eckabstands gewählten Kanalsymbol $y_1$. Im vorliegenden Fall wird nicht der kleinste Korrekturwert $z^{(diff)}$ sondern ein Sendewert $z_i^{(tx)}$:=0 gesendet,

da der gewünschten Empfangswert mit hoher Wahrscheinlichkeit allein durch die ISI-Anteile erreicht wird.

In allen übrigen Situationen (Fall C) wird beispielsweise der Anteil von $z^{(diff)}$, der sich auf die kleinere Komponente (real(),imag()) von $E_{i+m}^{ISIpost}$ bezieht, übertragen (S105). Dies ist in diesem Fall möglich, da bereits eine Komponente von $z^{(diff)}$ ausreicht, um basierend auf der vorausberechneten Unsicherheitsregion $S^{(rx)}(E^{ISIpost})$ einen sicheren Detektionsbereich für den Empfangswert zu erreichen. In Fall C ergibt sich also:

$$real(E_{i+m}^{ISIpost}) \leq imag(E_{i+m}^{ISIpost}) -> z_i^{(tx)} = real(z^{(diff)}) \tag{15a}$$

$$real(E_{i+m}^{ISIpost}) > imag(E_{i+m}^{ISIpost}) -> z_i^{(tx)} = imag(z^{(diff)}) \tag{15b}$$

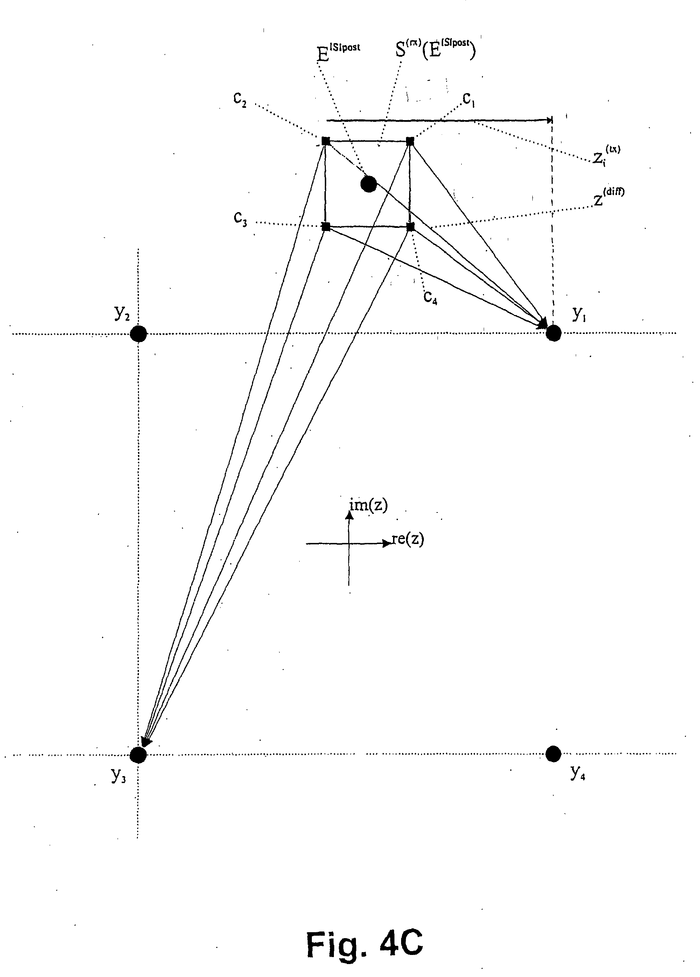

Fig. 4C zeigt eine dem Fall C entsprechende Konstellation für eine QPSK-Modulation, wobei wiederum das zu übertragende Informationssymbol $v^{(tx)}$ = +1 ist und somit die Kanalsymbole $y_1$ und $y_3$ wählbar sind. Die Unsicherheitsregion $S^{(rx)}(E^{ISIpost})$ befindet sich horizontal neben dem für das Informationssymbol $v_i^{(tx)}$ = +1 festgelegten Entscheidungsbereich gemäß Gleichung (14). Der kleinste Korrekturwert $z^{(diff)}$ entspricht dem Abstand zwischen dem entferntesten Eckpunkt $c_2$ und dem auf Grund des geringsten maximalen Eckabstands gewählten Kanalsymbol $y_1$. Im vorliegenden Fall ist es ausreichend, wenn der als horizontaler Pfeil angedeutete Realteil des kleinsten Korrekturwerts $z^{(diff)}$ als Sendewert $z_i^{(tx)}$ = $real(z^{(diff)})$ gesendet, da der gewünschten Empfangswert mit hoher Wahrscheinlichkeit allein durch eine Korrektur mittels des Realteils erreicht wird.

Im Schritt S106 kann dann eine Bereichsbegrenzung durch Begrenzung der komplexen Komponenten des gesendeten Sendewerts gemäß den nachfolgenden Gleichungen (16a) und (16b) erfolgen, um die maximale Sendeenergie zu begrenzen:

$$\left| real(z_i^{(tx)}) \right| > r_{max} -> real(z_i^{(tx)}) = sign(real(z_i^{(tx)})) \cdot r_{max} \tag{16a}$$

$$\left| imag(z_i^{(tx)}) \right| > r_{max} -> imag(z_i^{(tx)}) = sign(imag(z_i^{(tx)})) \cdot r_{max} \tag{16b}$$

Die Bereichsbegrenzung kann auch derart durchgeführt werden, daß der Betrag des komplexen gesendeten Signalwerts auf einen Maximalwert begrenzt wird.

Abschließend wird im Schritt S107 der für die Auswahl des nächsten Sendesymbols maßgebende Zeitpunkt inkrementiert, d.h. i=i+1.

In der Praxis ist die Menge Z der möglichen Sendewerte oft abzählbar (diskret, endliche Anzahl). In diesem Fall ist auch der Wertebereich von vielen in dem obigen Algorithmus berechneten Grössen, z.B. $E_{i+m}^{ISIpost}$, $z^{(max)}(k)$, abzählbar. Bereits vor der Übertragung können daher die möglichen Werte vieler Grössen vorausberechnet und in Wertetabellen abgelegt werden. Dadurch wird der Rechenzeitaufwand während der Übertragung minimiert.

Im Folgenden wird die Funktionsweise des in dem Empfänger 30 durchgeführten Decodierverfahrens anhand des prinzipiellen Flußdiagramms gemäß Fig 4 erläutert.

Im Schritt S 200 wird ein Empfangswert $z$ empfangen und dem Entscheider 31 zugeführt. Der Entscheider 31 vergleicht den Empfangswert mit vorgegebenen Entscheidungsregionen für die möglichen Kanalsymbole $y$ gemäß dem Kanalsymbolvorrat Y, um das empfangene Symbol zu ermitteln (S201). Dies entsprechend der Gleichung (2) erfolgen. Im Falle einer QPSK-Modulation kann es sich bei den empfangsseitigen Entscheidungsregionen beispielsweise um die Quadranten in der komplexen Ebene handeln.

Fig. 6 zeigt eine allgemeine Darstellung einer Entscheidungsregion für ein Kanalsymbol $y$ in der komplexen Ebene. Für einen Signalwert $z$, der innerhalb der Entscheidungsregion liegt, gibt der Entscheider 31 das entsprechende Kanalsymbol $y$ an den Zuordner 32 aus.

Im Schritt S202 der Fig. 5 erfolgt in dem Zuordner 32 eine Zuordnung zwischen dem ermittelten Kanalsymbol $y$ und dem zugehörigen Informationssymbol $v$ unter Zuhilfenahme einer Mappingfunktion f, die beispielsweise als Speichertabelle oder logische Funktion in dem Zuordner 32 bereitgestellt sein kann. Der Ablauf kehrt dann zurück zum Schritt S200, um auf den Empfang eines neuen Signalwerts zu warten.

Als näheres Beispiel wird nun der Fall betrachtet, dass das Informationssymbolalphabet zwei Zeichen umfasst, was zum Beispiel für BPSK gilt:

$$V = [v_1 = -1, \, v_2 = +1]. \tag{17}$$

Die Menge der möglichen Sendesymbole sei gegeben durch ein Quadrat der Kantenlänge $2r_{max}$ im Ursprung der komplexen Ebene, gemäß der nachfolgenden Definition:

$$Z^{(tx)}=\{z|-r_{max}<real(z)<r_{max}\wedge-r_{max}<imag(z)<r_{max}\} \qquad (18)$$

Als Kanalsymbolalphabet wird entsprechend einer QPSK-Modulation definiert:

$$Y =[y_1 = +1 + j,\ y_2 = -1 + j,\ y_3 = -1 - j,\ y_4 = +1 - j]. \qquad (19)$$

Für die Mappingfunktion $f(\cdot)$, die die Kanalsymbole im Zuordner 32 auf die Informationssymbole abbildet, ergibt sich somit:

$$\begin{aligned}
f(y_1 = +1 + j) &= +1 \\
f(y_2 = -1 + j) &= -1 \\
f(y_3 = -1 - j) &= +1 \\
f(y_4 = +1 - j) &= -1
\end{aligned} \qquad (20)$$

Damit existieren also p=2 für die Übertragung eines gegebenen Informationssymbols wählbare Kanalsymbole.

In Fig. 7 sind die als sicher angenommenen Entscheidungsregionen für die Kanalsymbole dargestellt. Die Berechnung der Sendewerte erfolgt so, dass die Empfangswerte mit hoher Wahrscheinlichkeit in die sicheren Entscheidungsregionen fallen. Da auf der Empfängerseite stets eine eindeutige Entscheidung getroffen werden muss, ist es zulässig, dort erweiterte, aneinander angrenzende Entscheidungsregionen wie z.B die vollständigen Quadranten zuzulassen.

Es wird angenommen, dass der Kanal kein starkes Vorschwingen aufweist und dass demzufolge gilt:

$$h_i << h_m \qquad für\ i < m. \qquad (21)$$

In der Praxis lässt sich ein solches Verhalten durch Einsatz eines linearen an den Kanal adaptierten Vorfilters sicherstellen.

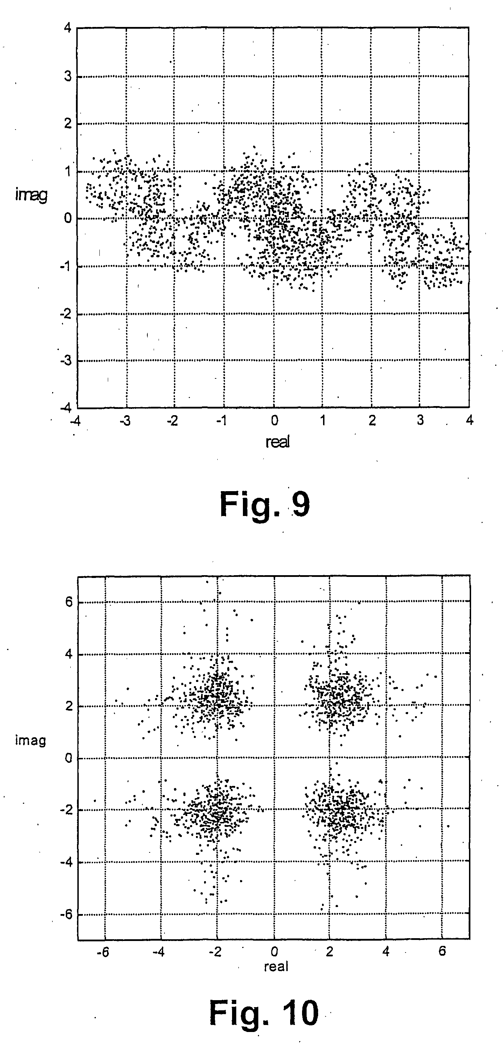

Fig. 8 zeigt die komplexe Kanalimpulsantwort eines vorschwingarmen Systems im Symboltakt. Gemäß dieser Kanalimpulsantwort ergibt sich eine Kanalordnung n=16 und eine Kanalverzögerung m=9, die im Sender 100 entsprechend zu berücksichtigen sind. Wird beispielsweise ein BPSK-Symbolstrom aus 2000 Symbolen über diesen Kanal übertragen, so erhält man am ohne überlagerte Rausch- oder Störsignale am Empfängereingang eine Konstellation gemäß Fig. 9. Offensichtlich ist auf Grund der kanalverursachten ISI ohne zusätzliche Ausgleichsmassnahmen keine fehlerfreie Detektion am Empfänger 30 möglich.

Verwendet man hingegen das oben beschriebenen MCP-Codierverfahren, so erhält man am Empfängereingang eine Konstellation gemäß Fig. 10. Dies entspricht vier Punktwolken, zwischen denen sich ein kreuzförmiger Freiraum gemäß Fig. 7 abzeichnet. Die Begrenzung nach den Gleichungen (16a) und (16b) wurde hier auf $r_{max} = 3$ eingestellt. Eine nachträgliche Analyse des Simulationsverlauf zeigt, dass von 2000 Symbolen 21 begrenzt wurden. Der Crestfaktor des Sendesymbolstroms lag bei ca. 2...2.5.

Ein einfacher Detektor, der anhand des Quadranten, in dem ein Empfangssymbol liegt, das zugrundeliegende Informationssymbol $v$ detektiert, würde in diesem Fall am Empfängerausgang einen fehlerfreien Empfangssymbolstrom liefern.

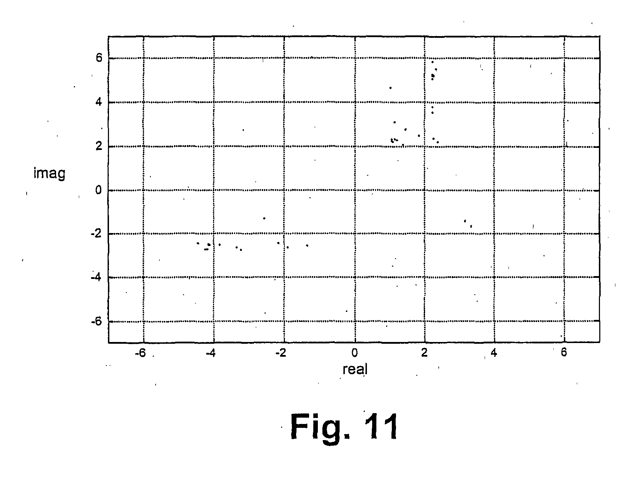

Im Folgenden wird die Scramblingfunktion als beiläufiger Vorteil des MCP-Codierverfahrens anhand der Darstellung in Fig. 11 erläutert. Fig. 11 zeigt eine Konstellation, die sich am Empfänger 30 ergibt, wenn eine konstante Folge von Informationssymbolen $v_i = 1$ übertragen wird. Gemäß Fig. 11 liegen die empfangsseitigen Signalwerte (Empfangswerte) in beiden dem Informationssymbol $v = +1$ zugeordneten Quadranten. Dadurch erhält das Empfangssignal zeitliche Änderungen, die eine Synchronisation auf der Empfängerseite erleichtern, ohne zusätzliche Descramblingmassnahmen zu erfordern.

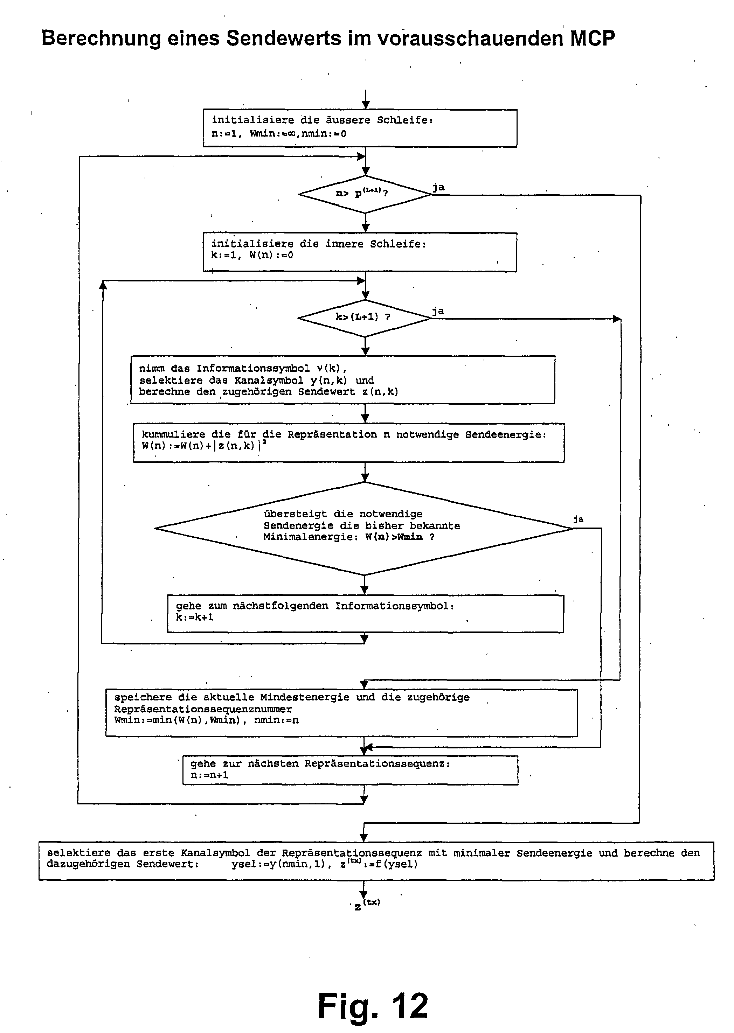

Das in der vorliegenden Anmeldung beschriebene Verfahren besteht zusammengefasst auch darin, für ein Informationssymbol, das von einem Sender zu einem Empfänger übertragen werden soll, aus p möglichen Repräsentationen (Kanalsymbolen) eine Auswahl zu treffen und den Sendewert zu ermitteln, der nötig ist, damit das ausgewählte Kanalsymbol im Empfängereingang erscheint. Als Auswahlkriterium dient die Minimierung der Energie des Sendewertes. Die Erfindung lässt sich insoweit auch als symbolweises Multiple-Choice-Precoding (MCP) bezeichnen. Eine Erweiterungsmöglichkeit der symbolweisen MCP ist ein vorausschauendes MCP, wie es in einem Flussdiagramm nach Figur 12 dargestellt ist. Hierbei ergibt sich bei der Berücksichtigung von L zukünftige zu sendende Informationssymbole und p möglichen Repräsentationen eine Gesamtzahl von $p^{(L+1)}$ Repräsentationssequenzen. Dementsprechend enthält das Flussdiagramm eine äußere Schleife über $p^{(L+1)}$ Repräsentationssequenzen. Jede Repräsentationssequenz besteht aus (L+1) Kanalsymbolen und den zugehörigen Sendewerten. Demzufolge ist in dem Flussdiagramm eine innere Schleife dargestellt. In dieser inneren Schleife werden die Energiewerte der Sendewerte aufaddiert. Die innere Schleife endet, wenn entweder alle (L+1) Werte berechnet wurden, oder wenn die Energiesumme das bisherige Minimum überschreitet. Im letzteren Fall ist ein vorzeitiger Abbruch möglich, da sicher ist, dass die Gesamtsendeenergie der aktuellen Repräsentationssequenz größer ist als die Gesamtsendeenergie mindestens einer anderen zuvor berechneten Repräsentationssequenz. Nach der Abarbeitung der äußeren Schleife ist die Repräsentationssequenz bekannt, deren Summe der Sendeenergiewerte minimal ist. Da das Auswahlkriterium die Minimierung der Gesamtenergie einer Sendewertsequenz ist, wird das erste Kanalsymbol der Repräsentationssequenz mit minimaler Summe der Sendeenergiewerte als Kanalsymbol für das aktuell zu sendende Informationssymbol selektiert. In gleicher Weise wie in dem nach Figur 2 beschriebenen Verfahren wird der Sendewert als Funktion des selektierten Kanalsymbols berechnet und ausgesendet. Der besondere Vorteil des vorausschauenden MCP gegenüber dem symbolweisen MCP besteht in der Minimierung der mittleren und maximalen Sendewertenergie. Formal lässt sich die Berechnung des vorausschauenden MCP als ein Problem definieren, dass darin besteht, eine Sequenz von diskreten Entscheidungen derart zu fällen, dass eine Kostenfunktion minimiert wird. Für Probleme dieser Art nach der typischen Aufgabenstellung "finde eine optimale Entscheidungssequenz" existieren in der Mathematik Lösungsansätze wie z.B. "Dynamik-Programming", die gegenüber der bereits beschriebenen Methode des Durchprobierens effektiver in der Rechengeschwindigkeit aber weitaus komplexer in der Implementierung und Beschreibung sind. Daher soll hier nur darauf verwiesen werden, dass der MCP-Ansatz im Gegensatz zu anderen Vorkodierungsverfahren die Nutzung bekannter, hochentwickelter Optimierungsalgorithmen erschließt. Beispielsweise lässt sich die Tatsache, dass die bei MCP zu minimierende Gesamtenergie eine quadratische Funktion ist, nutzen, um die Berechnung der Sendewerte als ein quadratisches Optimierungsproblem (Quadratic Programming) zu formulieren. Die allgemeine Form des quadratischen Optimierungsproblems (sowie ein entsprechender Lösungsalgorithmus) ist beispielsweise in der Optimierungstoolbox des Programms MATLAB definiert und lautet:

$$\min_{x} \quad x^T \cdot H \cdot x + f^T x \quad , A \cdot x <= b$$

Setzt man nur für x die Real- und Imaginärteile einer Sendewertsequenz, für H die Einheitsmatrix, für f den Nullvektor, für A die Faltungsmatrix, die sich aus der bekannten Kanalimpulsantwort bilden lässt und für b die Real- und Imaginärteile einer Repräsentationssequenz ein, so lässt sich nun mit den allgemeinen Methoden der Optimierungstheorie diese Repräsentationssequenz im Sinne der Energieminimierung optimale Sequenz der Sendewerte berechnen. Dies ist mit einem gewissen numerischen Aufwand verbunden. Der Vorteil dieses Ansatzes besteht jedoch darin, dass mit der vorliegenden Erfindung (MCP) damit auch auf Kanälen mit beliebigem Vorschwingen anwendbar ist, ohne dass der Einsatz eines FIR-Filters notwendig wäre.

Wie gezeigt, beinhaltet der beschriebene Algorithmus bei hinreichend verzerrungsreichen Kanälen implizit eine Scramblingfunktion. Um auch bei verzerrungsfreien bzw. verzerrungsarmen Kanälen eine Scramblingfunktion zu gewährleisten, kann das anzustrebende Kanalsymbol $y^{(tx)}$ beispielsweise zufällig gewählt werden. Auf diese Weise ist für jede Informationssymbolfolge eine gute Dynamik in der Empfangssymbolfolge und damit die Codetransparenz des Verfahrens sichergestellt.

Das erfindungsgemäße Codierverfahren (MCP) basiert auf der Grundidee eines gegenüber dem Informationssymbolalphabet mächtigeren Kanalsymbolalphabets, d.h. das Kanalsymbolalphabet umfaßt zumindest ein Element mehr als das Informationssymbolalphabet. Unter Einsatz eines erhöhten Linearitäts- und Dynamikbereiches auf der Sendeseite wird bei minimalem Aufwand auf Empfängerseite die kanalverursachte Intersymbolinterferenz drastisch reduziert. Da auf Senderseite vorausberechnet wird, welche Werte auf der Empfängerseite unter dem Kanaleinfluss erfasst werden, ist die Kenntnis der Kanalimpulsantwort auf der Senderseite notwendig. In Anbetracht der Tatsache, dass auch etwaige Filter- und Synchronisationsoperationen im Empfänger Einfluss auf die resultierende Kanalimpulsantwort haben, können und sollten diese Operationen einfach oder zumindest auf der Senderseite vorhersehbar sein. Einen Anhaltspunkt für die Leistungsfähigkeit des MCP-Verfahrens geben die per Simulation gewonnenen Konstellationen am Empfängereingang.

In der Praxis existieren Situationen, in denen zu einem Sendezeitpunkt $j$ neben dem aktuellen Informations-symbol bereits die nachfolgenden L zu übertragenden Informationssymbole $v_j, v_{j+1}, ... v_{j+L}$ bekannt sind. Eine Erweiterungsmöglichkeit des Ausführungsbeispiels besteht daher in der Berücksichtigung dieser zukünftigen L Informationssymbole bei der Bestimmung des aktuellen Sendewerts $z^{(tx)}$. Dazu werden beispielsweiswe sämtliche mögliche Kanalsymbolsequenzen $y_{k_j}, y_{k_{j+1}}, ... y_{k_{j+L}}$, die zur Repräsentation der Informationssymbolsequenz $v_j, v_{j+1}, ... v_{j+L}$ in Betracht kommen, vorausberechnet. Der aktuellen Sendewert $z^{(tx)}_j$ wird dann derart bestimmt, dass sich eine minimale vorausichtlich benötigte Sendeenergie, d.h.

$$\min\left(\sum_{i=j}^{j+L} |z_i|^2\right),$$

für die nächsten L Symbole ergibt, dass alle $z_i$ in der Menge der möglichen Sendesymbole enthalten sind, d.h. d.h. $z_i \in Z^{(tx)}$ ($i = j, j+1, ... j+L$), und dass die Detektion auf der Empfängerseite voraussichtliche für alle $z_i$ fehlerfrei möglich ist, d.h. $D^{err}_j < 0$ ($i = j, j+1, ... j+L$).

Da mittels MCP Equalisationsrechenleistung auf der Empfängerseite freisetzt wird, ist es möglich diese Rechenleistung entweder völlig einzusparen oder sie zur weiteren Verbesserung der Übertragung einzusetzen. Beispielsweise ist es möglich zusätzlich zu MCP auf der Empfängerseite einen adaptiven Equalizer vorzusehen, der der in der Praxis zwangsläufig auftretenden Abweichung zwischen der gemessenen Kanalimpulsantwort und der realen Kanalimpulsantwort folgt und diese kompensiert. Der Vorteil gegenüber einer Lösung ohne MCP besteht darin, dass der adaptive Equalizer mit MCP nur die Verzerrungsanteile entzerren muss, die auf Grund der Abweichung zwischen der gemessenen Kanalimpulsantwort und der realen oder wirksamen Kanalimpulsantwort im Empfangswert enthalten sind. Gegenüber einer Lösung ohne MCP kann dies mit niedrigerer numerischer Auflösung und damit niedrigeren Kosten erfolgen.

Das MCP-Verfahren ist beispielsweise in vorteilhafter Weise in Anwendungen einsetzbar, bei denen zeitinvariante Kanäle mit starken Reflektionen die Kommunikation zwischen einer Basisstation und vielen Teilnehmerstationen als Hauptstörquelle stören, wie beispielsweise WLL-Systeme. Selbstverständlich ist das MCP-Verfahren auch bei höherstufigen PSK- und bei DPSK-Modulationsverfahren oder auch bei anderen geeigneten Modulationsarten in vorteilhafter Weise einsetzbar.

Darüber hinaus ist auch ersichtlich, dass mittels MCP die bitfolgeunabhängige Synchronisation bei allen Datenraten erleichtert und damit verbilligt werden kann.

**Patentansprüche**

1. Verfahren zur Codierung eines über einen Übertragungskanal (20) zu übertragenden Informationssymbols, mit den Schritten:

   a) Bereitstellen eines Kanalsymbolalphabets, das zumindest ein Element mehr aufweist als das Informationssymbolalphabet,
   b) Bestimmen des Nachschwingverhaltens des Übertragungskanals (20),
   c) Vorausberechnen von beim Übertragen wählbarer Kanalsymbole am Ende des Übertragungskanals (20) erwarteten Empfangssignalwerten basierend auf dem Nachschwingverhalten und bereits gesendeten Kanalsymbolen,
   d) Auswählen eines der wählbaren Kanalsymbole unter Berücksichtigung der erwarteten Empfangssignalwerte,
   e) Verwenden des ausgewählten Kanalsymbols zur Codierung des zu übertragenden Informationssymbols, und
   f) Berechnen eines Sendesignalwerts in Abhängigkeit des ausgewählten Kanalsymbols und der erwarteten Empfangswerte.

2. Verfahren nach Anspruch 1, wobei für jedes Informationssymbol zumindest zwei Kanalsymbole bereitgestellt werden.

3. Verfahren nach Anspruch 1, wobei die erwarteten Empfangssignalwerte eine Unsicherheitsregion definieren und die Auswahl des wählbaren Kanalsymbols basierend auf dessen Lage bezüglich der Unsicherheitsregion erfolgt.

4. Verfahren nach Anspruch 3, wobei die Unsicherheitsregion unter Berücksichtigung des Vorschwingverhaltens des Übertragungskanals (20) bestimmt wird.

5. Verfahren nach Anspruch 4, wobei das Vor- und Nachschwingverhalten des Übertragungskanals (20) anhand der Kanalimpulsantwort ermittelt wird.

6. Verfahren nach einem der vorgenannten Ansprüche, wobei ein adaptiver Equalizer zur Kompensation einer Abweichung zwischen gemessener und realer Kanalimpulsantwort auf der Empfängerseite verwendet wird.

7. Verfahren nach Anspruch 3 oder 4, wobei dasjenige wählbare Kanalsymbol ausgewählt wird, welches den kleinsten Korrekturwert bezüglich der Eckpunkte der Unsicherheitsregion aufweist.

8. Verfahren nach Anspruch 3 oder 4, wobei dasjenige wählbare Kanalsymbol ausgewählt wird, welches den kleinsten Korrekturwert bezüglich des am weitesten entfernten Punktes der Unsicherheitsregion aufweist.

9. Verfahren nach einem der vorgenannten Ansprüche, wobei der Sendewert "0" zur Übertragung eines Kanalsymbols verwendet wird, falls sich der erwartete durch ISI verursachte Empfangssignalwert innerhalb eines Bereiches befindet, der mit hoher Wahrscheinlichkeit zur Detektion des zu übertragenen Kanalsymbols auf Empfängerseite führt.

10. Verfahren nach einem der vorgenannten Ansprüche, wobei die Differenz zwischen dem ausgewählten Kanalsymbol und der im ungünstigsten Fall zu erwartenden Intersymbolinterferenz als Sendewert zur Übertragung des zu übertragenden Kanalsymbols verwendet wird, falls sich der entsprechende erwartete Empfangssignalwert innerhalb eines definierten durch Kanalsymbole aufgespannten Bereichs befindet.

11. Verfahren nach einem der vorgenannten Ansprüche, wobei eine Bereichsbegrenzung derart durchgeführt wird, dass die komplexen Komponenten des gesendeten Signalwerts jeweils auf einen Maximalwert begrenzt werden.

12. Verfahren nach einem der vorgenannten Ansprüche, wobei eine Bereichsbegrenzung derart durchgeführt wird, dass der Betrag eines komplexen gesendeten Signalwerts auf einen Maximalwert begrenzt wird.

13. Verfahren nach einem der vorgenannten Ansprüche, wobei das zu übertragende Informationssymbol ein BPSK-Symbol und die wählbaren Kanalsymbole QPSK-Symbole sind.

14. Verfahren nach einem der vorgenannten Ansprüche, wobei die Menge der Sendewerte nicht abzählbar ist.

15. Verfahren nach einem der vorgenannten Ansprüche, wobei die Menge der Sendewerte abzählbar und damit diskret ist.

16. Verfahren nach Anspruch 15, wobei eine Pre-Codierer-Funktion nach Ermittlung der Kanaleigenschaften in Form einer wertetabelle realisiert wird.

17. Verfahren nach Anspruch 16, wobei die Pre-Codierer-Funktion bereits vor der genauen Ermittlung der Kanaleigenschaften in Form einer Wertetabelle für wahrscheinliche Typen von Kanalimpulsantworten realisiert wird.

18. Verfahren nach einem der vorgenannten Ansprüche, wobei der Sendewert unter Berücksichtigung möglicher für nachfolgende zu übertragende Informationssymbole verwendbarer Kanalsymbolsequenzen bestimmt wird.

19. Verfahren nach einem der vorgenannten Ansprüche, wobei die Auswahl der Kanalsymbole zur Erzielung einer Scramblingfunktion zufällig erfolgt.

20. Verfahren nach einem der vorgenannten Ansprüche, wobei eine höherstufige PSK-Modulation oder eine DPSK-Modulation zur Codierung verwendet wird.

21. Verfahren zum Decodieren eines über einen Übertragungskanal (20) empfangenen Empfangssignalwerts, mit den Schritten:

a) Ermitteln eines Kanalsymbols aus dem Empfangssignalwert unter Verwendung einer Entscheidungsfunktion, und

b) Zuordnen eines Informationssymbols, für welches das ermittelte Kanalsymbol bei der Codierung auswählbar ist,

c) Bestimmen einer Detektionsunsicherheit anhand des Abstands zwischen dem Empfangssignalwert und der Grenze eines für das ermittelte Kanalsymbol verwendeten sicheren Entscheidungsbereichs,

d) wobei der Abstand ein euklidischer Abstand oder eine Hamming-Distanz ist,

e) wobei das Kanalsymbol ein QPSK-Symbol ist und die Ermittlung des Kanalsymbols anhand des Quadranten erfolgt, in dem sich der Empfangssignalwert befindet.

22. Vorrichtung zur Codierung eines über einen Übertragungskanal (20) zu übertragenden Informationssymbols, mit:

a) einem Codierer (11) zum Bereitstellen von zumindest zwei wählbaren Kanalsymbolen für das zu übertragende Informationssymbol,

b) einer Berechnungseinrichtung (12, 13, 14, 15) zum Vorausberechnen der beim Übertragen der wählbaren Kanalsymbole am Ende des Übertragungskanals (20) erwarteten Empfangssignalwerte basierend auf dem Nachschwingverhalten des Übertragungskanals (20) und bereits gesendeten Sendewerten,

c) einer Selektionseinrichtung (12) zum Auswählen eines der wählbaren Kanalsymbole unter Berücksichtigung der erwarteten Empfangssignalwerte, und zum Verwenden des ausgewählten Kanalsymbols zur Codierung des zu übertragenden Informationssymbols, und

d) einer Sendewertberechnungseinrichtung (15) zur Berechnung des Sendewerts in Abhängigkeit des ausgewählten Kanalsymbols und der erwarteten Empfangswerte.

23. Vorrichtung nach Anspruch 22, wobei die Berechnungseinrichtung (12, 13, 14, 15) umfasst eine erste Speichereinrichtung (14) zum Speichern der bereits gesendeten Sendewerte, eine zweite Speichereinrichtung (13) zum Speichern von das Nachschwingen des Übertragungskanals (20) beschreibenden Kanalkoeffizienten, eine Multiplikationseinrichtung zum Multiplizieren der bereits gesendeten Sendewerte mit den zugehörigen Kanalkoeffizienten, und eine Additionseinrichtung zum Aufaddieren der Multiplikationsergebnisse.

24. Vorrichtung nach Anspruch 23, wobei die erwarteten Empfangssignalwerte die in der Berechnungseinrichtung (12, 13, 14, 15) anhand des Additionsergebnisses, des ausgewählten Kanalsymbols und eines das Vorschwingverhalten des Übertragungskanals (20) berücksichtigenden Erwartungswerts vorausberechnet werden.

25. Vorrichtung nach einem der Ansprüche 22 bis 24, wobei ein an den Übertragungskanal (20) adaptiertes Vorfilter zur Verringerung des Vorschwingverhaltens des Übertragungskanals vorgesehen ist.

26. Vorrichtung zum Decodieren eines über einen Übertragungskanal (20) empfangenen Empfangssignalwerts, mit:

a) einer Entscheidungseinrichtung (31) zum Ermitteln eines Kanalsymbols aus dem Empfangssignalwert unter Verwendung einer Entscheidungsfunktion,

b) einer Zuordnungseinrichtung (32) zum Zuordnen eines Informationssymbols, für welches das ermittelte Kanalsymbol bei der Codierung auswählbar ist, und

c) einer Fehlerbeurteilungseinrichtung (32) zum Bestimmen einer Detektionsunsicherheit anhand des Abstands zwischen dem Empfangssignalwert und der Grenze eines für das ermittelte Kanalsymbol als sicher betrachteten Entscheidungsbereichs,

d) wobei die Entscheidungseinrichtung (31) einen Detektor aufweist, in dem das Kanalsymbol anhand des den Empfangssignalwert aufweisenden Quadranten ermittelt wird.

27. Verfahren nach einem der vorhergehenden Ansprüche 1 bis 21, wobei zur Auswahl des aktuellen Kanalsymbols eine Menge von zukünftig zu übertragenden Informationssymbolen berücksichtigt wird.

28. Verfahren nach einem der vorhergehenden Ansprüche 1 bis 21, **dadurch gekennzeichnet, dass** die mittlere und maximale Sendewertenergie durch die Berücksichtigung von zukünftig zu übertragenden Informationssymbolen bei der Auswahl des aktuellen Kanalsymbols minimiert wird.

**EP 1 317 829 B1**

**Claims**

1. Method for encoding an information symbol to be transmitted via a transmission channel (20), with the steps:

   a) furnishing a channel symbol alphabet which has at least one more element than the information symbol alphabet,
   b) determining the postoscillation behaviour of the transmission channel (20),
   c) calculating in advance the reception signal values anticipated at the end of the transmission channel (20) when transmitting selectable channel symbols, based on the postoscillation behaviour and channel symbols already sent,
   d) selecting one of the selectable channel symbols, taking into account the anticipated reception signal values,
   e) using the selected channel symbol for encoding the information symbol to be transmitted, and
   f) calculating a transmitting signal value as a function of the selected channel symbol and the anticipated reception values.

2. Method according to claim 1, wherein at least two channel symbols are provided for each information symbol.

3. Method according to claim 1, wherein the anticipated reception signal values define a region of uncertainty and the selectable channel symbol is chosen based on its position relative to the region of uncertainty.

4. Method according to claim 3, wherein the region of uncertainty is determined in consideration of the preoscillation behaviour of the transmission channel (20).

5. Method according to claim 4, wherein the preoscillation and postoscillation behaviour of the transmission channel (20) is determined by means of the channel pulse response.

6. Method according to any one of the preceding claims, wherein an adaptive equaliser is used to compensate for a deviation between measured and real channel pulse response at the receiver side.

7. Method according to claim 3 or 4, wherein that selectable channel symbol is selected which has the smallest correction value relative to the corner points of the region of uncertainty.

8. Method according to claim 3 or 4, wherein that selectable channel symbol is selected which has the smallest correction value relative to the most distant point of the region of uncertainty.

9. Method according to any one of the preceding claims, wherein the transmitting value "0" is used to transmit a channel symbol if the anticipated reception signal value caused by ISI is located within a region that leads with high probability to the detection of the channel symbol to be transmitted at the receiver side.

10. Method according to any one of the preceding claims, wherein the difference between the selected channel symbol and the intersymbol interference anticipated in the worst case is used as a transmitting value to transmit the channel symbol being sent if the corresponding anticipated reception signal value is located inside a region defined and subtended by channel symbols.

11. Method according to any one of the preceding claims, wherein limiting of the region is carried out in such a way that the complex components of the sent signal value are each limited to a maximum value.

12. Method according to any one of the preceding claims, wherein limiting of the region is carried out in that the amplitude of a complex sent signal value is limited to a maximum value.

13. Method according to any one of the preceding claims, wherein the information symbol to be transmitted is a BPSK symbol and the selectable channel symbols are QPSK symbols.

14. Method according to any one of the preceding claims, wherein the set of transmitting values is not countable.

15. Method according to any one of the preceding claims, wherein the set of transmitting values is countable and thus discrete.

**16.** Method according to claim 15, wherein a pre-encoder function is achieved in the form of a table of values after determining the channel properties.

**17.** Method according to claim 16, wherein the pre-encoding function is achieved in the form of a table of values for probable types of channel pulse responses even prior to the exact determination of the channel properties.

**18.** Method according to any one of the preceding claims, wherein the transmitting value is determined in consideration of possible channel symbol sequences which can be used for subsequent information symbols to be transmitted.

**19.** Method according to any one of the preceding claims, wherein the selection of channel symbols is random in order to accomplish a scrambling function.

**20.** Method according to any one of the preceding claims, wherein a higher-stage PSK modulation or a DPSK modulation is used for encoding.

**21.** Method for decoding a reception signal value received via a transmission channel (20), with the steps:

a) determining a channel symbol from the reception signal value by using a decision-making function, and
b) assigning an information symbol, for which the determined channel symbol is selectable during encoding,
c) determining a detection uncertainty by means of the distance between the reception signal value and the limits of a secure decision-making region used for the determined channel symbol,
d) wherein the distance is a Euclidean distance or a Hamming distance,
e) wherein the channel symbol is a QPSK symbol and the channel symbol is determined by using the quadrant in which the reception signal value is located.

**22.** Device for encoding an information signal to be transmitted via a transmission channel (20), with:

a) an encoder (11) for furnishing at least two selectable channel symbols for the information symbol to be transmitted,
b) a computing unit (12, 13, 14, 15) for computing in advance the reception signal values anticipated at the end of the transmission channel (20) when transmitting the selectable channel symbols, based on the postoscillation behaviour of the transmission channel (20) and the transmitting values already sent,
c) a selection unit (12) for selecting one of the selectable channel symbols in consideration of the anticipated reception signal values, and for using the selected channel symbol to encode the information symbol to be transmitted, and
d) a transmitting value computing unit (15) for computing the transmitting value as a function of the selected channel symbol and the anticipated reception values.

**23.** Device according to claim 22, wherein the computing unit (12, 13, 14, 15) comprises a first storage unit (14) for storing the transmitting values already sent, a second storage unit (13) for storing the channel coefficients describing the postoscillation of the transmission channel (20), a multiplication unit for multiplying the transmitting values already sent with the corresponding channel coefficients, and an addition unit for adding up the results of the multiplication.

**24.** Device according to claim 23, wherein the anticipated reception signal values are calculated in advance in the computing unit (12, 13, 14, 15) by means of the addition result, the selected channel symbol, and an anticipation value which takes into account the preoscillation behaviour of the transmission channel (20).

**25.** Device according to any one of claims 22 to 24, wherein a prefilter adapted to the transmission channel (20) is provided for diminishing the preoscillation behaviour of the transmission channel.

**26.** Device for decoding a reception signal value received via a transmission channel (20), with:

a) a decision-making unit (31) for determining a channel symbol from the reception signal value by using a decision-making function,
b) an assignment unit (32) for assigning an information symbol for which the determined channel symbol is selectable during encoding, and
c) an error assessment unit (32) for determining a detection uncertainty based on the distance between the reception signal value and the limits of a decision-making region considered to be secure for the determined channel symbol,

d) wherein the decision-making unit (31) has a detector, in which the channel symbol is determined by means of the quadrant having the reception signal value.

27. Method according to any one of the preceding claims 1 to 21, wherein a set of information symbols to be transmitted in future is taken into account in selecting the current channel symbol.

28. Method according to any one of the preceding claims 1 to 24, **characterised in that** the mean and maximum transmitting value energy is minimised by taking into account future information symbols to be transmitted when selecting the current channel symbol.

**Revendications**

1. Procédé de codage d'un symbole d'information devant être transmis par l'intermédiaire d'un canal de transmission (20), comprenant les étapes consistant à :

    a) préparer un alphabet de symboles de canal, qui comporte au moins un élément de plus que l'alphabet des symboles d'information,
    b) déterminer le comportement de postoscillation du canal de transmission (20),
    c) calculer préalablement des valeurs du signal de réception attendues lors de la transmission de canaux de symboles pouvant être sélectionnés du canal à la fin du canal de transmission (20), sur la base du comportement de postoscillation et de symboles du canal déjà émis,
    d) sélectionner l'un des symboles pouvant être sélectionnés du canal en tenant compte des valeurs attendues du signal de réception,
    e) utiliser le symbole sélectionné du canal pour coder le symbole d'information à transmettre, et
    f) calculer une valeur du signal d'émission en fonction du symbole de canal sélectionné et des valeurs de réception attendues.

2. Procédé selon la revendication 1, selon lequel au moins deux symboles du canal sont préparés pour chaque symbole d'information.

3. Procédé selon la revendication 1, selon lequel les valeurs attendues du signal de réception définissent une région d'incertitude et la sélection du symbole de canal pouvant être sélectionné s'effectue sur la base de la position de ce symbole par rapport à la région d'incertitude.

4. Procédé selon la revendication 3, selon lequel la région d'incertitude est déterminée en fonction du comportement de préoscillation du canal de transmission (20).

5. Procédé selon la revendication 4, selon lequel le comportement de préoscillation et le comportement de postoscillation du canal de transmission (20) sont déterminés sur la base de la réponse impulsionnelle du canal.

6. Procédé selon l'une des revendications précédentes, selon lequel on utilise un égaliseur adaptatif pour la compensation d'un écart entre la réponse impulsionnelle de canal mesurée et la réponse impulsionnelle de canal réelle côté récepteur.

7. Procédé selon la revendication 3 ou 4, selon lequel on sélectionne le symbole de canal pouvant être sélectionné, qui présente la valeur de correction la plus faible par rapport aux points d'angle de la région d'incertitude.

8. Procédé selon la revendication 3 ou 4, selon lequel on sélectionne le canal pouvant être sélectionné, qui possède la plus faible valeur de correction par rapport au point, qui est le plus éloigné, de la région d'incertitude.

9. Procédé selon l'une des revendications précédentes, selon lequel la valeur d'émission "0" est utilisée pour la transmission d'un symbole de canal, dans le cas où la valeur attendue du signal de réception, produite par une interférence ISI, est située dans une zone qui conduit avec une probabilité élevée à la détection du symbole de canal à transmettre, côté récepteur.

**10.** Procédé selon l'une des revendications précédentes, selon lequel la différence entre le symbole de canal sélectionné et l'interférence entre symboles, à laquelle il faut s'attendre dans le cas le plus défavorable, est utilisée en tant que valeur d'émission pour la transmission du symbole de canal à transmettre, dans le cas où la valeur correspondante attendue du signal de réception est située dans une zone définie, qui est englobée par les symboles du canal.

**11.** Procédé selon l'une des revendications précédentes, selon lequel une délimitation de zone est exécutée par le fait que les composants complexes de la valeur émise du signal sont limités respectivement à une valeur maximale.

**12.** Procédé selon l'une des revendications précédentes, selon lequel une délimitation de zone est exécutée par le fait que la valeur absolue d'une valeur complexe émise du signal est limitée à une valeur maximale.

**13.** Procédé selon l'une des revendications précédentes, selon lequel le symbole d'information à transmettre est un symbole BPSK et les symboles pouvant être sélectionnés du canal sont des symboles QPSK.

**14.** Procédé selon l'une des revendications précédentes, selon lequel la quantité des valeurs d'émission ne peut pas être comptée.

**15.** Procédé selon l'une des revendications précédentes, selon lequel la quantité des valeurs d'émission peut être comptée et par conséquent est discrète.

**16.** Procédé selon la revendication 15, selon lequel une fonction de pré-codeur est réalisée après détermination des caractéristiques du canal sous la forme d'un tableau de valeurs.

**17.** Procédé selon la revendication 16, selon lequel la fonction de pré-codeur est réalisée déjà avant la détermination précise des caractéristiques du canal sous la forme d'un tableau de valeurs pour des types probables de réponses impulsionnelles du canal.

**18.** Procédé selon l'une des revendications précédentes, selon lequel la valeur d'émission est déterminée en tenant compte de séquences de symboles du canal pouvant être utilisées pour des symboles d'information suivants à transmettre.

**19.** Procédé selon l'une des revendications précédentes, selon lequel la sélection des symboles du canal s'effectue de façon aléatoire pour l'obtention d'une fonction de brouillage.

**20.** Procédé selon l'une des revendications précédentes, selon lequel on utilise une modulation PSK à niveau supérieur ou une modulation DPSK pour le codage.

**21.** Procédé pour le décodage d'une valeur de signal de réception reçue par l'intermédiaire d'un canal de transmission (20), comprenant les étapes consistant à :

a) déterminer un symbole du canal à partir de la valeur du signal de réception en utilisant une fonction de décision, et
b) associer un symbole d'information, pour lequel le symbole déterminé du canal peut être sélectionné lors du codage,
c) déterminer une incertitude de détection sur la base de l'écart entre la valeur du signal de réception et la limite d'une zone de décision sûre utilisée pour le symbole déterminé du canal,
d) l'écart étant une distance euclidienne ou une distance de Hamming,
e) le symbole de canal étant un symbole QPSK, et la détermination du symbole du canal s'effectuant sur la base du quadrant, dans lequel est située la valeur du signal de réception.

**22.** Dispositif pour le codage d'un symbole d'information à transmettre par l'intermédiaire d'un canal de transmission (20), comportant :

a) un codeur (11) servant à préparer au moins deux symboles pouvant être sélectionnés du canal pour le symbole d'information à transmettre,
b) un dispositif de calcul (12,13,14,15) pour réaliser le calcul préalable des valeurs du signal de réception, qui sont attendues lors de la transmission des symboles pouvant être sélectionnés du canal à la fin du canal de transmission (20), sur la base du comportement de postoscillation du canal de transmission (20) et des valeurs d'émission déjà émises,

c) un dispositif de sélection (12) pour sélectionner l'un des symboles pouvant être sélectionnés du canal en tenant compte des valeurs attendues du signal de réception et pour utiliser le symbole sélectionné du canal pour le codage du symbole d'information à transmettre, et

d) un dispositif (15) de calcul de la valeur d'émission pour calculer la valeur d'émission en fonction du symbole sélectionné du canal et des valeurs de réception attendues.

23. Dispositif selon la revendication 22, dans lequel le dispositif de calcul (12,13,14,15) comprend un premier dispositif de mémoire (14) pour mémoriser les valeurs d'émission déjà émises, un second dispositif de mémoire (13) pour mémoriser des coefficients du canal décrivant la postoscillation du canal de transmission (20), un dispositif de multiplication pour multiplier les valeurs d'émission déjà émises avec les coefficients associés du canal, et un dispositif d'addition pour additionner les résultats de multiplication.

24. Dispositif selon la revendication 23, dans lequel les valeurs attendues du signal de réception, qui sont calculées préalablement dans le dispositif de calcul (12,13,14,15) sur la base du résultat d'addition, du symbole sélectionné du canal et d'une valeur attendue prenant en compte le comportement de préoscillation du canal de transmission (20).

25. Dispositif selon l'une des revendications 22 à 24, dans lequel un filtre amont, adapté au canal de transmission (20), est prévu pour réduire le comportement de préoscillation du canal de transmission.

26. Dispositif pour le décodage d'une valeur du signal de réception reçu par l'intermédiaire d'un canal de transmission (20), comportant :

a) un dispositif de décision (31) pour déterminer un symbole du canal à partir de la valeur du signal de réception, en utilisant une fonction de décision,

b) un dispositif d'association (32) pour associer un symbole d'information, pour lequel un symbole déterminé du canal peut être sélectionné lors du codage, et

c) un dispositif d'évaluation d'erreur (32) pour déterminer une incertitude de détection sur la base de l'écart entre la valeur du signal de réception et la limite d'une zone de décision considérée comme sûre pour le symbole déterminé du canal,

d) le dispositif de décision (31) comportant un détecteur dans lequel le symbole de canal est déterminé sur la base du quadrant contenant la valeur du signal de réception.

27. Procédé selon l'une des revendications 1 à 21, dans lequel pour la sélection du symbole actuel du canal, on prend en compte une quantité de symboles d'information à transmettre ultérieurement.

28. Procédé selon l'une des revendications 1 à 21, **caractérisé en ce que** les énergies moyenne et maximale de la valeur d'émission sont réduites par la prise en compte de symboles d'information devant être transmis ultérieurement, lors de la sélection du symbole actuel du canal.

# Fig. 1

# Fig. 2

Bestimmung des Vor- und Nachschwingverhaltens
des Übertragungskanals

S100

Ermittlung der durch ISI hervorgerufenen
Unsicherheitsregion für den voraussichtlichen
Empfangszeitpunkt des aktuellen Sendewerts

S101

Auswahl des Kanalsymbols mit kleinstem
Korrekturwert bzgl. Unsicherheitsregion

S102

In „innerem
Bereich" (Fall A)

Lage des
erw. Werts?

übrige
Situationen (Fall C)

im angestr.
Entsch.bereich (Fall B)

Sendewert:=
minimaler
Maximalabstand

S103

Sendewert:=0

S104

Senden einer
kompl. Komp. des
minimalen
Maximalabstands
S105

Bereichsbegrenzung
S106

i=i+1
S107

# Fig. 3

Fig. 4A

Fig. 4B

Fig. 4C

Empfangen eines Empfangswerts
S200

Ermittlung des empfangenen Kanalsymbols
S201

Zuordnung des zugeh. Informationssymbols
S202

Empfangswert
innerhalb der sicheren
Entscheidungsregion?

nein

ja

Anzeige einer
Übertragungsunsicherheit
S204

# Fig. 5

Im(z)

sichere
Entscheidungsregion für
Kanalsymbol y

z

BordDist(z,y)

Re(z)

# Fig. 6

# Fig. 7

# Fig. 8

Fig. 9

Fig. 10

Fig. 11

# Berechnung eines Sendewerts im vorausschauenden MCP

initialisiere die äussere Schleife:
n:=1, Wmin:=∞,nmin:=0

n> P$^{(L+1)}$? → ja

initialisiere die innere Schleife:
k:=1, W(n):=0

k>(L+1) ? → ja

nimm das Informationssymbol v(k),
selektiere das Kanalsymbol y(n,k) und
berechne den zugehörigen Sendewert z(n,k)

kummuliere die für die Repräsentation n notwendige Sendeenergie:
W(n):=W(n)+|z(n,k)|$^2$

übersteigt die notwendige
Sendenergie die bisher bekannte
Minimalenergie: W(n)>Wmin ? → ja

gehe zum nächstfolgenden Informationssymbol:
k:=k+1

speichere die aktuelle Mindestenergie und die zugehörige
Repräsentationssequenznummer
Wmin:=min(W(n),Wmin), nmin:=n

gehe zur nächsten Repräsentationssequenz:
n:=n+1

selektiere das erste Kanalsymbol der Repräsentationssequenz mit minimaler Sendeenergie und berechne den
dazugehörigen Sendewert:     ysel:=y(nmin,1), z$^{(tx)}$:=f(ysel)

z$^{(tx)}$

# Fig. 12